# EUROPEAN PATENT SPECIFICATION

(11) **EP 4 376 575 B1**
(45) Date of publication and mention of the grant of the patent: **21.01.2026**
(21) Application number: 23211196.3
(22) Date of filing: 21.11.2023
(51) Int. Cl.: H10K 59/122, H10K 71/60, H10K 50/824, H10K 50/816

(54) **DISPLAY PANEL AND METHOD OF MANUFACTURING THE SAME**
ANZEIGETAFEL UND VERFAHREN ZUR HERSTELLUNG DAVON
PANNEAU D'AFFICHAGE ET SON PROCÉDÉ DE FABRICATION

(30) Priority: 22.11.2022 KR 20220157498
(43) Date of publication of application: 29.05.2024
(73) Proprietor: Samsung Display Co., Ltd., Gyeonggi-Do (KR)
(72) Inventor: SHIN, Hyuneok, Yongin-si (KR); KWON, Sungjoo, Yongin-si (KR); PARK, Joonyong, Yongin-si (KR)
(74) Representative: Marks & Clerk LLP

(56) References cited:
- US-A1- 2007 263 164
- US-A1- 2008 231 168

## Description

### BACKGROUND

### 1. Field

The disclosure herein relates to a display panel and a method of manufacturing the same, and more particularly, to a display panel capable of achieving a high-resolution display and having improved process efficiency and a method of manufacturing the same.

### 2. Description of the Related Art

A display panel is included in various multimedia devices such as a television, a mobile phone, a tablet computer, a game console, etc., to provide image information to users. The display panel may include a light-emitting element and a pixel circuit for driving the light-emitting element. The light-emitting elements included in the display panel emit light in response to a voltage applied from the pixel circuit and generate images. US 2007/263164 A1 relates to a display device and manufacturing method thereof. US 2008/231168 A1 relates to a display substrate, organic light emitting diode display device and manufacturing method thereof.

### SUMMARY

In a case where a display panel is a high resolution display panel, it is desired to develop a method for patterning a light-emitting element of the display panel to achieve a high-resolution display and improve reliability.

The disclosure provides a display panel capable of achieving a high-resolution display.

The disclosure provides a method of manufacturing a display panel capable of improving process efficiency.

An embodiment of the invention provides a display panel including: a base layer; a lower electrode disposed on the base layer; a protection pattern which is disposed on the lower electrode, where a lower opening partially exposing an upper surface of the lower electrode is defined in the protection pattern; a pixel-defining film which is disposed on the base layer and covers at least a portion of the protection pattern, where a light-emitting opening corresponding to the lower opening is defined in the pixel-defining film; a conductive partition wall which is disposed on the pixel-defining film, where a partition wall opening corresponding to the light-emitting opening is defined in the conductive partition wall; a light-emitting pattern disposed in the lower opening, the light-emitting opening, and the partition wall opening and disposed on the lower electrode; and an upper electrode disposed on the light-emitting pattern, and in contact with an inner surface of the conductive partition wall defining the partition wall opening. In such an embodiment, the protection pattern includes a first layer including molybdenum tantalum oxide (MoTaOₓ) and disposed on the lower electrode, and a second layer including a transparent conductive oxide and disposed on the first layer.

In an embodiment, the first layer may be in direct contact with the lower electrode, and the second layer may be not in contact with the lower electrode.

In an embodiment, the lower electrode may include a plurality of layers. The lower electrode may have a multi-layered structure of indium tin oxide (ITO)/Ag/ITO.

In an embodiment, the first layer may have a thickness less than that of the second layer.

In an embodiment, the first layer may have a thickness in a range of about 50 angstrom (Å) to about 200 Å.

In an embodiment, the first layer may contain tantalum (Ta) in an amount of about 2 atomic percent (at%) or greater.

In an embodiment, the transparent conductive oxide may include indium zinc oxide (IZO), zinc oxide (ZnO), or indium gallium zinc oxide (IGZO).

In an embodiment, the conductive partition wall may include a first conductive layer disposed on the pixel-defining film and having a first conductivity, and a second conductive layer having a second conductivity less than the first conductivity, and disposed on the first conductive layer.

In an embodiment, the first conductive layer may have a first thickness, and the second conductive layer may have a second thickness less than the first thickness.

In an embodiment, on a plane, a side surface of the second conductive layer may protrude further toward a center of the lower electrode than a side surface of the first conductive layer does.

In an embodiment, the display panel may include: a first inorganic encapsulation film disposed on the upper electrode and the conductive partition wall; an organic encapsulation film disposed on the first inorganic encapsulation film; and a second inorganic encapsulation film disposed on the organic encapsulation film.

In an embodiment, the display panel may further include a dummy pattern disposed on the conductive partition wall, wherein the dummy pattern may include a first dummy layer including a same light-emitting material as a light-emitting material included in the light-emitting pattern, and a second dummy layer disposed on the first dummy layer and including a same material as a material included in the upper electrode.

In an embodiment, the display panel may further include a capping pattern disposed between the upper electrode and the first inorganic encapsulation film.

In an embodiment, the opening may have a greater planar area than the light-emitting opening.

In an embodiment of the invention, a method of manufacturing a display panel includes: preparing a preliminary display panel including a base layer, a lower electrode disposed on the base layer, a protection pattern disposed on the lower electrode, a preliminary pixel-defining film covering the lower electrode and the protection pattern, a preliminary conductive partition wall disposed on the preliminary pixel-defining film; forming a partition wall opening corresponding to the lower electrode in the preliminary conductive partition wall; forming a light-emitting opening in the preliminary pixel-defining film; forming an opening in the protection pattern; forming a light-emitting pattern, by depositing a light-emitting material onto the lower electrode, inside the partition wall opening, the light-emitting opening, and the opening; and providing an upper electrode on the light-emitting pattern. In such an embodiment, the protection pattern includes a first layer disposed on the lower electrode and a second layer disposed on the first layer, and the opening is formed by performing a single etching process on the first layer and the second layer.

In an embodiment, the single etching process may include a wet-etching process and a cleaning process, the second layer may include a transparent conductive oxide and be removed through the wet-etching process, and the first layer may include molybdenum tantalum oxide (MoTaOₓ) and be removed through the cleaning process.

In an embodiment, the forming the light-emitting opening may be performed through a dry-etching process and the forming the opening may be performed through a wet-etching process, and an inner surface of the pixel-defining film defining the light-emitting opening may be more adjacent to a center of the lower electrode than an inner surface of the protection pattern defining the opening is.

In an embodiment, the method may further include providing a dummy pattern on the conductive partition wall. In such an embodiment, the providing the dummy pattern may include forming a first dummy layer by depositing, onto the conductive partition wall, a material the same as the light-emitting material, and forming a second dummy layer by depositing, onto the first dummy layer, an electrode material the same as a material included in the upper electrode.

In an embodiment, the preliminary conductive partition wall may include a first conductive layer and a second conductive layer disposed on the first conductive layer, the forming of the partition wall opening may include forming a preliminary partition wall opening in the preliminary conductive partition wall by dry-etching the first and the second conductive layers, and forming the partition wall opening in the preliminary partition wall opening by wet-etching the first and the second conductive layers such that a conductive partition wall is formed from the preliminary conductive partition wall, and the first conductive layer may have a greater etch rate than the second conductive layer.

At least some of the above and other features of the invention are set out in the claims.

### BRIEF DESCRIPTION OF THE DRAWINGS

The above and other features of the invention will become more apparent by describing in further detail embodiments thereof with reference to the accompanying drawings, in which:
FIG. 1A is a perspective view of a display device according to an embodiment of the invention;
FIG. 1B is an exploded perspective view of a display device according to an embodiment of the invention;
FIG. 2 is a cross-sectional view of a display module according to an embodiment of the invention;
FIG. 3 is a plan view of a display panel according to an embodiment of the invention;
FIG. 4 is an enlarged plan view of a portion of a display region of a display panel according to an embodiment of the invention;
FIGS. 5A and 5B are cross-sectional views of a display panel according to embodiments of the invention;
FIG. 6 is an enlarged cross-sectional view of a region of a display panel according to an embodiment of the invention;
FIGS. 7A to 7C are cross-sectional views respectively illustrating some operations of a method of manufacturing a display panel according to an embodiment of the invention;
FIGS. 8A to 8D are cross-sectional views respectively illustrating some operations of a method of manufacturing a display panel according to an embodiment of the invention; and
FIGS. 9A to 9D are cross-sectional views respectively illustrating some operations of a method of manufacturing a display panel according to an embodiment of the invention.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

In this specification, it will be understood that when an element (or a region, a layer, a portion, or the like) is referred to as "being on", "connected to" or "coupled to" another element, it may be directly disposed on/connected/coupled to the other element, or intervening elements may be disposed therebetween.

Meanwhile, in this specification, it will be understood that "being directly disposed" means that there are no intervening layers, films, regions, plates or the like between a portion of layers, films, regions, plates or the like and another portion. For example, "being directly disposed" may mean to be disposed between two layers or two members without using an additional member such as an adhesive member or like.

Like reference numerals or symbols refer to like elements throughout. In the drawings, the thickness, the ratio, and the dimension of the elements are exaggerated for effective description of the technical contents.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes all combinations of one or more of the associated listed elements.

Although the terms first, second, etc. may be used to describe various elements, these elements should not be limited by these terms. These terms are only used to distinguish one element from another element. For example, a first element may be referred to as a second element, and similarly, a second element may also be referred to as a first element without departing from the teachings therein.

The terms such as "below", "lower", "above", "upper" and the like, may be used herein for the description to describe one element's relationship to another element illustrated in the figures. It will be understood that the terms have a relative concept and are described on the basis of the orientation depicted in the figures. In this specification, "being disposed on" may mean to be disposed not only on an upper part but also on a lower part of one member.

It will be understood that the term "includes" or "comprises", when used in this specification, specifies the presence of stated features, integers, steps, operations, elements, components, or a combination thereof, but does not preclude the presence or addition of one or more other features, integers, steps, operations, elements, components, or combinations thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which the disclosure belongs. Also, terms, such as those defined in commonly used dictionaries, should be interpreted as having a meaning that is consistent with their meaning in the context of the relevant art and should not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the invention will be described with reference to the accompanying drawings.

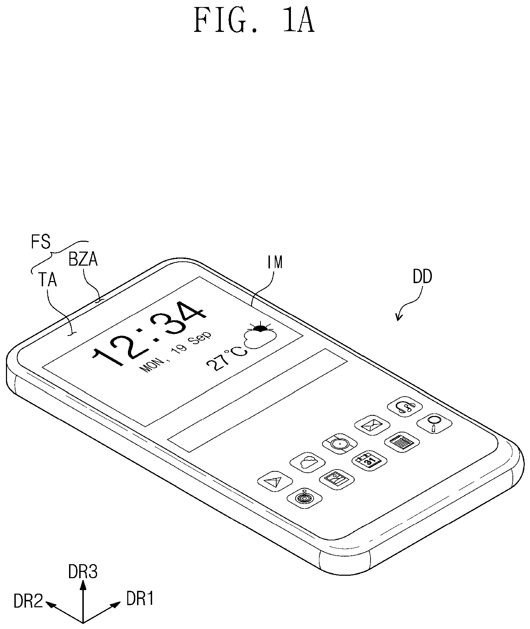

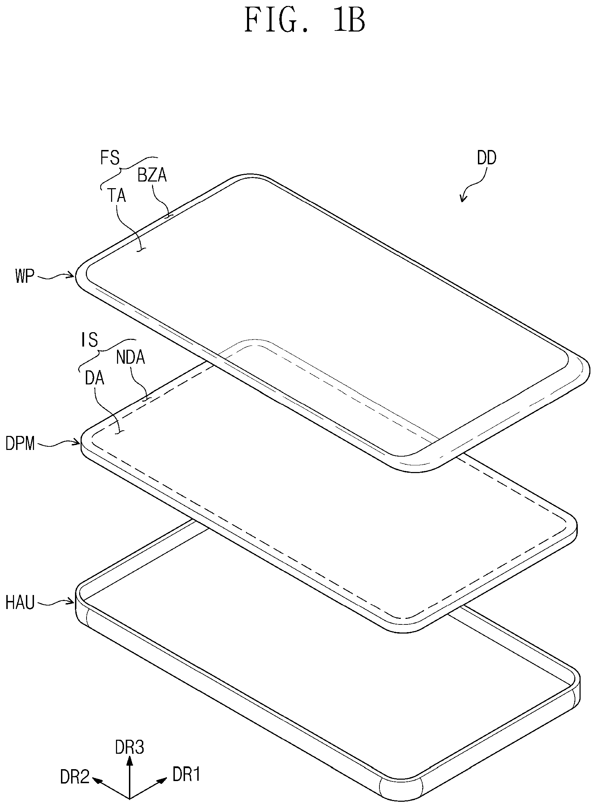

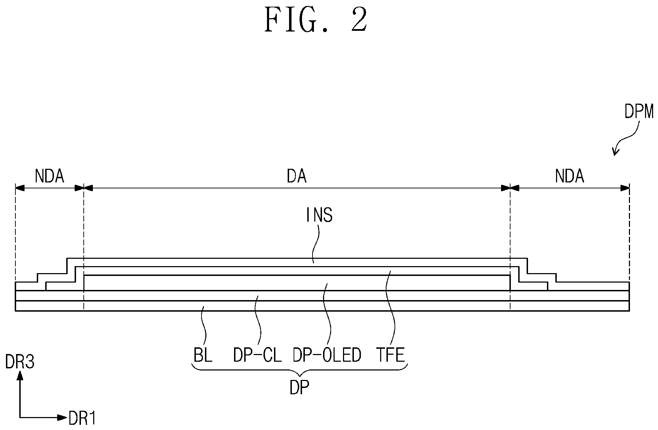

FIG. 1A is a perspective view of a display device according to an embodiment of the invention. FIG. 1B is an exploded perspective view of a display device according to an embodiment of the invention. FIG. 1B schematically illustrates an exploded perspective view of a display device DD illustrated in FIG. 1A according to an embodiment of the invention. FIG. 2 is a cross-sectional view of a display panel according to an embodiment of the invention.

The display device DD according to an embodiment may be an electronic device that is activated in response to an electrical signal. In an embodiment, for example, the display device DD may be a large-sized electronic device such as a television, a monitor, or an external billboard. In an embodiment, the display device DD may be a small-sized or medium-sized electronic device such as a personal computer, a laptop computer, a personal digital terminal, a car navigation system, a game console, a mobile phone, a tablet computer, or a camera. These are merely examples, and an embodiment of the invention is not limited thereto. In FIG. 1A, an embodiment where the display device DD is a smart phone is illustrated as an example.

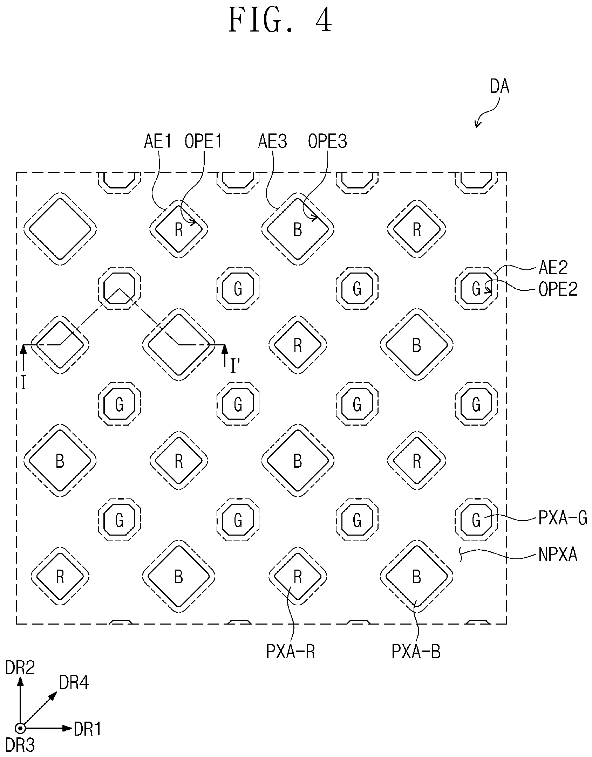

In FIG. 1A and the following drawings, a first direction DR1, a second direction DR2, a third direction DR3, and a fourth direction DR4 (see FIG. 4) are illustrated, and the directions indicated by the first to the fourth directions DR1, DR2, DR3, and DR4 described herein have relative concepts, and thus may be changed to other directions. In addition, the directions opposite to the directions indicated by the first to fourth directions DR1, DR2, DR3, and DR4 may also be referred to as first to fourth directions, respectively, and may be denoted as the same reference numerals or symbols. In this specification, the term "on a plane" or "when viewed in a plan view" may mean when viewed in the third direction DR3. The third direction DR3 may be a thickness direction of the display device DD.

Referring to FIGS. 1A and 1B, the display device DD according to an embodiment may include a display surface FS parallel to a plane defined by the first direction DR1 and the second direction DR2 crossing the first direction DR1. The display device DD may provide an image IM to a user through the display surface FS. The display device DD according to an embodiment may display the image IM, in the third direction DR3, on the display surface FS parallel to each of the first direction DR1 and the second direction DR2. In an embodiment, as shown in FIG. 1A, the image IM may be a clock display and application icons, for example. The display surface FS on which the image IM is displayed may correspond to the front surface of the display device DD.

In this specification, a front surface (or upper surface) and a rear surface (or lower surface) of each component may be defined on the basis of a direction in which the image IM is displayed. The front surface and the rear surface may be opposed to each other in the third direction DR3, and a normal direction of each of the front surface and the rear surface may be parallel to the third direction DR3.

As illustrated in FIG. 1B, the display device DD according to an embodiment may include a window WP, a display module DPM, and a housing HAU. The window WP and the housing HAU may be coupled to each other to constitute the exterior of the display device DD.

The window WP may include an optically transparent insulating material. In an embodiment, for example, the window WP may include glass or plastic. The front surface of the window WP may define the display surface FS of the display device DD. The display surface FS may include a transmission region TA and a bezel region BZA. The transmission region TA may be an optically transparent region. In an embodiment, for example, the transmission region TA may have a visible light transmittance of about 90% or greater.

The bezel region BZA may be a region having a relatively lower light transmittance than the transmission region TA. The bezel region BZA may define a shape of the transmission region TA. In an embodiment, the bezel region BZA may be adjacent to the transmission region TA and surround the transmission region TA. Such an embodiment is merely illustrated in FIGS. 1A and 1B as an example, and in the window WP according to an alternative embodiment of the invention, the bezel region BZA may be omitted. The window WP may include at least one functional layer among an anti-fingerprint layer, a hard coating layer, and an anti-reflection layer, but is not limited to any one embodiment.

The display module DPM may be disposed under the window WP. The display module DPM may be a component that substantially generates the image IM. The image IM generated in the display module DPM may be displayed on a display surface IS of the display module DPM and be viewed by a user in the outside through the transmission region TA.

The display surface IS of the display module DPM may include a display region DA and a non-display region NDA. The display region DA may be a region activated in response to an electrical signal. The non-display region NDA may be adjacent to the display region DA. The non-display region NDA may surround the display region DA. The non-display region NDA may be a region covered by the bezel region BZA and may be invisible to the outside.

The housing HAU may be coupled to the window WP to constitute the exterior of the display device DD and may provide or define a predetermined inner space in the display device DD. The housing HAU may include a material having a relatively higher stiffness. In an embodiment, for example, the housing HAU may include a plurality of frames and/or plates including or formed of glass, plastic, or metal. The display module DPM may be accommodated in the inner space to be protected against an external impact.

Additionally, the display device DD according to an embodiment may further include an electronic module (not illustrated) disposed below the display module DPM. In an embodiment, for example, the electronic module (not illustrated) may include a camera module. In some embodiments, the display device DD may include an adhesive layer and/or a polarizing film which are disposed between the display module DPM and the window WP. The display device DD may further include a lower functional layer disposed below the display module DPM.

Referring to FIG. 2, a display module DPM according to an embodiment may include a display panel DP and an input sensor INS. Although not illustrated separately, the display device DD according to an embodiment of the invention may further include a protection member disposed on a lower surface of the display panel DP or an anti-reflection member and/or a window member disposed on an upper surface of the input sensor INS.

The display panel DP may be a light-emitting display panel, but is not particularly limited. In an embodiment, for example, the display panel DP may be an organic light-emitting display panel or an inorganic light-emitting display panel. A light-emitting layer in the organic light-emitting display panel may include an organic light-emitting material. A light-emitting layer in the inorganic light-emitting display panel may include a quantum dot, a quantum rod, or a micro light emitting diode (LED). Hereinafter, for convenience of description, embodiments where the display panel DP is an organic light-emitting display panel will be described, but not being limited thereto.

The display panel DP may include a base layer BL, a circuit element layer DP-CL disposed on the base layer BL, a display element layer DP-OLED, and an encapsulation layer TFE. The input sensor INS may be directly disposed on the encapsulation layer TFE. In this specification, the wording, "an A component is directly disposed on a B component" means that another component is not disposed between the A component and the B component. For example, an additional adhesive layer may not be disposed between an A component and a B component.

The base layer BL may be a member providing a base surface on which the circuit element layer DP-CL is disposed. The base layer BL may be a rigid substrate or a flexible substrate capable of bending, folding, rolling, or the like. The base layer BL may include at least one plastic film. Alternatively, the base layer BL may include a plastic substrate, a glass substrate, a metal substrate, an organic/inorganic composite material substrate, or the like. In this specification, the display region DA and the non-display region NDA are defined in the base layer BL, and in this case, it may also be considered that components disposed on the base layer BL are disposed to overlap the display region DA or the non-display region NDA.

The circuit element layer DP-CL may be disposed on the base layer BL. The circuit element layer DP-CL may include at least one insulating layer and a circuit element. The insulating layer may include at least one inorganic layer and at least one organic layer. The circuit element may include signal lines, a driving circuit of a pixel, and the like.

The display element layer DP-OLED may be disposed on the circuit element layer DP-CL. The display element layer DP-OLED may include a conductive partition wall and a light-emitting element. In an embodiment, for example, the light-emitting element may include an organic light-emitting material, an inorganic light-emitting material, an organic-inorganic light-emitting material, a quantum dot, a quantum rod, a micro LED, or a nano LED.

The encapsulation layer TFE may be disposed on the display element layer DP-OLED. The encapsulation layer TFE may cover the display element layer DP-OLED. The encapsulation layer TFE may include a plurality of thin films. At least one thin film among the thin films may be disposed to improve optical efficiency, and at least another thin film among the thin films may be disposed to protect the display element layer DP-OLED against foreign substances such as moisture, oxygen, and dust particles.

The input sensor INS may be disposed on the display panel DP. The input sensor INS may acquire coordinate information about the external input. The external input may be a user's input. The user's input may include various types of external inputs such as a part of a user's body, light, heat, pen, pressure, or like. The input sensor INS may have a multi-layered structure. The input sensor INS may include a single- or multi-layered conductive layer. The input sensor INS may include a single-layered or multi-layered insulating layer. In an embodiment, for example, the input sensor INS may detect an external input in a capacitive manner. According to an embodiment of the invention, an operating method of the input sensor INS is not particularly limited, and the input sensor INS may detect an external input in an electromagnetically inductive manner or in a pressure-sensitive manner. According to an alternative embodiment of the invention, the input sensor INS may be omitted.

The input sensor INS may be formed on the display panel DP through a continuous process. In this case, the input sensor INS may be directly disposed on the display panel DP. In an embodiment, for example, the input sensor INS may be directly disposed on the encapsulation layer TFE of the display panel DP. Also, the input sensor INS may be coupled to the display panel DP via an adhesive member. The adhesive member may include a typical bonding agent or an adhesive agent.

In an embodiment, an optical layer may be further disposed on the input sensor INS. The optical layer may be directly disposed on the input sensor INS. The optical layer may be formed on the input sensor INS through a continuous process. The optical layer may reduce reflectance caused by external light incident from the outside of the display module DPM. The optical layer may include a polarizing layer or a color filter layer. In an embodiment, the input sensor INS may be omitted, and the optical layer may be directly disposed on the display panel DP. In an embodiment, the positions of the input sensor INS and the optical layer may be exchanged with each other.

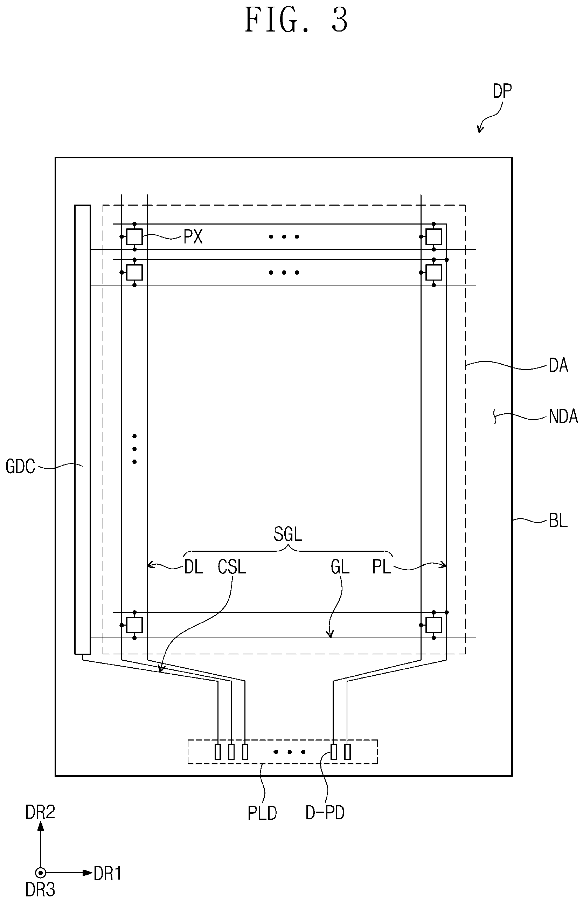

FIG. 3 is a plan view of a display panel according to an embodiment of the invention. Referring to FIG. 3, a display panel DP may include the base layer BL in which the display region DA and the non-display region NDA are defined, as illustrated with reference to FIG. 2.

The display panel DP may include pixels PX disposed in the display region DA and signal lines SGL electrically connected to the pixels PX. The display panel DP may include a driving circuit GDC and a pad portion PLD which are disposed in the non-display region NDA.

The pixels PX may be arranged in the first direction DR1 and the second direction DR2. The pixels PX may include a plurality of pixel rows which extend in the first direction DR1 and are aligned in the second direction DR2, and a plurality of pixel columns which extend in the second direction DR2 and are aligned in the first direction DR1.

The signal lines SGL may include gate lines GL, data lines DL, a power line PL, and a control signal line CSL. Each of the gate lines GL may be respectively connected to a corresponding pixel among the pixels PX, and each of the data lines DL may be respectively connected to a corresponding pixel among the pixels PX. The power line PL may be electrically connected to the pixels PX. The control signal line CSL may be connected to the driving circuit GDC to provide control signals to the driving circuit GDC.

The driving circuit GDC may include a gate driving circuit. The gate driving circuit may generate gate signals and sequentially output the generated gate signals to the gate lines GL. The gate driving circuit may further output another control signal to a pixel driving circuit.

The pad portion PLD may be a portion to which a flexible circuit board is connected. The pad portion PLD may include pixel pads D-PD, which may be pads for connecting the flexible circuit board to the display panel DP. The pixel pads D-PD may be respectively connected to corresponding signal lines among the signal lines SGL. The pixel pads D-PD may be connected to the corresponding pixels PX through the signal lines SGL. In addition, one pixel pad among the pixel pads D-PD may be connected to the driving circuit GDC.

In an embodiment, the pad portion PLD may further include input pads. The input pads may be pads for connecting the flexible circuit board to the input sensor INS (see FIG. 2). However, an embodiment of the invention is not limited thereto, and the input pads may be disposed in the input sensor INS (see FIG. 2) and be connected to a circuit board separately from the pixel pads D-PD. Alternatively, the input sensor INS (see FIG. 2) may be omitted, and input pads may not be further included.

FIG. 4 is an enlarged plan view of a portion of a display region of a display panel according to an embodiment of the invention. FIG. 4 is a plan view of the display module DPM (see FIG. 1B) as viewed from above the display surface IS (FIG. 1B) of the display module DPM (see FIG. 1B) (or in the third direction DR3) and illustrates an arrangement of light-emitting regions PXA-R, PXA-G, and PXA-B.

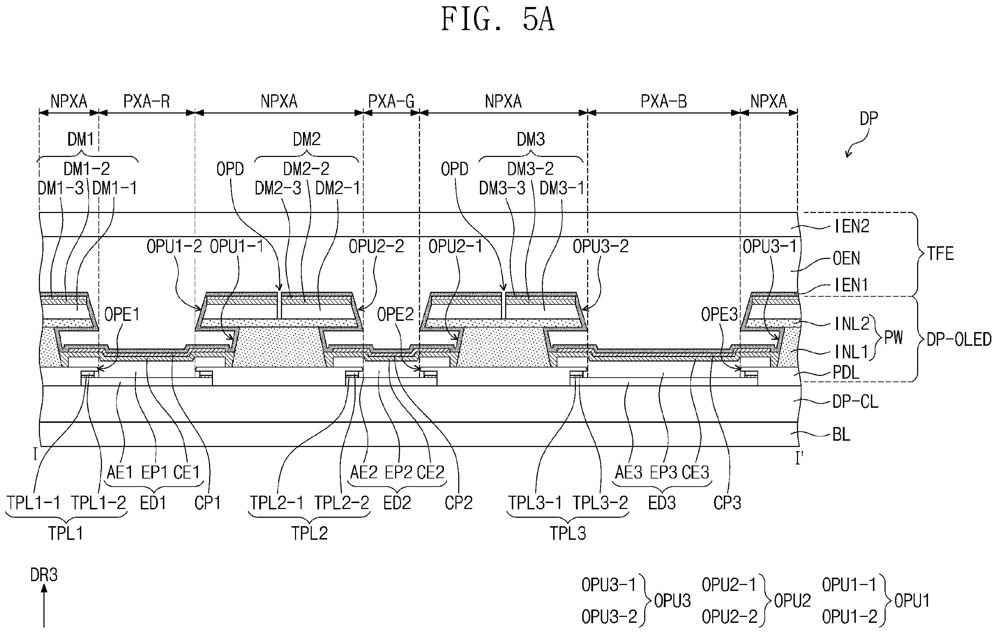

Referring to FIG. 4, a display region DA may include first to third light-emitting regions PXA-R, PXA-G, and PXA-B and a non-light-emitting region NPXA surrounding the first to third light-emitting regions PXA-R, PXA-G, and PXA-B. The first to third light-emitting regions PXA-R, PXA-G, and PXA-B may respectively correspond to regions where light provided from light-emitting elements ED1, ED2, and ED3 (see FIG. 5A) is emitted.

For ease of illustration and description, FIG. 4 schematically illustrates only lower electrodes AE1, AE2, and AE3 among components of the light-emitting elements ED1, ED2, and ED3 (see FIG. 5A). The first to third light-emitting regions PXA-R, PXA-G, and PXA-B may be distinguished based on the color of light emitted toward the outside of the display module DPM (see FIG. 2).

The first to third light-emitting regions PXA-R, PXA-G, and PXA-B may respectively provide first-color light to third-color light having different colors. In an embodiment, for example, the first color light may be red light, the second color light may be green light, and the third color light may be blue light. However, examples of the first to third color light are not necessarily limited to the examples described above.

The first to third light-emitting regions PXA-R, PXA-G, and PXA-B may be respectively defined as regions where the upper surfaces of the corresponding lower electrodes AE1, AE2, and AE3 are exposed by the corresponding light-emitting openings OPE1, OPE2, and OPE3. The light-emitting openings OPE1, OPE2, and OPE3 may be defined by a pixel-defining film PDL (see FIG. 5A) partially covering the lower electrodes AE1, AE2, and AE3, and this will be described later in greater detail.

In an embodiment, for example, the first light-emitting region PXA-R may be defined as a region where the upper surface of the first lower electrode AE1 is exposed by the first light-emitting opening OPE1. In addition, the second light-emitting region PXA-G may be defined as a region where the upper surface of the second lower electrode AE2 is exposed by the second light-emitting opening OPE2. Further, the third light-emitting region PXA-B may be a region where the upper surface of the third lower electrode AE3 is exposed by the third light-emitting opening OPE3.

The non-light-emitting region NPXA may define boundaries between the first to third light-emitting regions PXA-R, PXA-G, and PXA-B and prevent color-mixing between the first to third light-emitting regions PXA-R, PXA-G, and PXA-B.

The first to third light-emitting regions PXA-R, PXA-G, and PXA-B may be each provided in plurality, and be repeatedly arranged in a predetermined arrangement form within a display region DA. In an embodiment, for example, the plurality of first light-emitting regions PXA-R and the plurality of third light-emitting regions PXA-B may be alternately arranged along the first direction DR1 and form a 'first group'. In addition, the plurality of second light-emitting regions PXA-G may be arranged along the first direction DR1 and form a 'second group'. The 'first group' and the 'second group' may be each provided in plurality, and the 'first groups' and the 'second groups' may be alternately arranged along the second direction DR2.

One second light-emitting region PXA-G may be disposed to be spaced apart from one first light-emitting region PXA-R or one third light-emitting region PXA-B in the fourth direction DR4. On a plane defined by the first direction DR1 and the second direction DR2, the fourth direction DR4 may be defined as a direction between the first direction DR1 and the second direction DR2.

In an embodiment, as illustrated in FIG. 4, the first to third light-emitting regions PXA-R, PXA-G, and PXA-B may be arranged in a PENTILE^{®} form. However, the arrangement form of the first to third light-emitting regions PXA-R, PXA-G, and PXA-B illustrated in FIG. 4 is merely illustrated as an example but is not limited thereto. The first to third light-emitting regions PXA-R, PXA-G, and PXA-B may be arranged in various forms. In an embodiment, for example, the first to third light-emitting regions PXA-R, PXA-G, and PXA-B may be arranged in a stripe form or a Diamond Pixel^{™} form.

The first to third light-emitting regions PXA-R, PXA-G, and PXA-B may have various shapes on a plane. In an embodiment, for example, the first to third light-emitting regions PXA-R, PXA-G, and PXA-B may each have a shape of polygon, circle, oval, or the like. FIG. 4 illustrates an embodiment where on a plane, the first light-emitting regions PXA-R and the third light-emitting regions PXA-B have quadrilateral shapes (or rhombic shape) and the second light-emitting region PXA-G has an octagonal shape.

The first to third light-emitting regions PXA-R, PXA-G, and PXA-B may have identical or similar shapes or have at least partially different shapes on a plane. FIG. 4 illustrates an embodiment where on a plane, the first light-emitting regions PXA-R and the third light-emitting regions PXA-B have a same shape as each other, and the second light-emitting regions PXA-G have a different shape from the respective shapes of the first light-emitting regions PXA-R and the third light-emitting regions PXA-B.

At least some of the first to third light-emitting regions PXA-R, PXA-G, and PXA-B may have different areas on a plane or different planar areas from each other. In an embodiment, for example, the area of the first light-emitting region PXA-R that emits red light may be greater than the area of the second light-emitting region PXA-G that emits green light and may be less than the area of the third light-emitting region PXA-B that emits blue light. However, the area size relationship between the first to third light-emitting regions PXA-R, PXA-G, and PXA-B according to the color of emitted light is not limited thereto, and may vary according to a design of the display module DPM (see FIG. 2). In an embodiment, for example, the first to third light-emitting regions PXA-R, PXA-G, and PXA-B may have the same area on a plane.

In embodiments of the invention, the planar shape, planar area, and planar arrangement of the first to third light-emitting regions PXA-R, PXA-G, and PXA-B of the display module DPM (see FIG. 2) may be variously designed based on the color of emitted light, or the size, or configuration of the display module DPM (see FIG. 2), and are not limited to the embodiment illustrated in FIG. 4.

The lower electrodes AE1, AE2, and AE3 may be connected to driving circuits of pixels within the circuit element layer DP-CL (see FIG. 2) described above via connection contact holes (not illustrated). The connection contact holes may be disposed to be spaced apart from the light-emitting regions PXA-R, PXA-G, and PXA-B respectively defined in the lower electrodes AE1, AE2, and AE3. Alternatively, the connection contact holes may be disposed to overlap at least a portion of the light-emitting regions PXA-R, PXA-G, and PXA-B respectively defined in the lower electrodes AE1, AE2, and AE3.

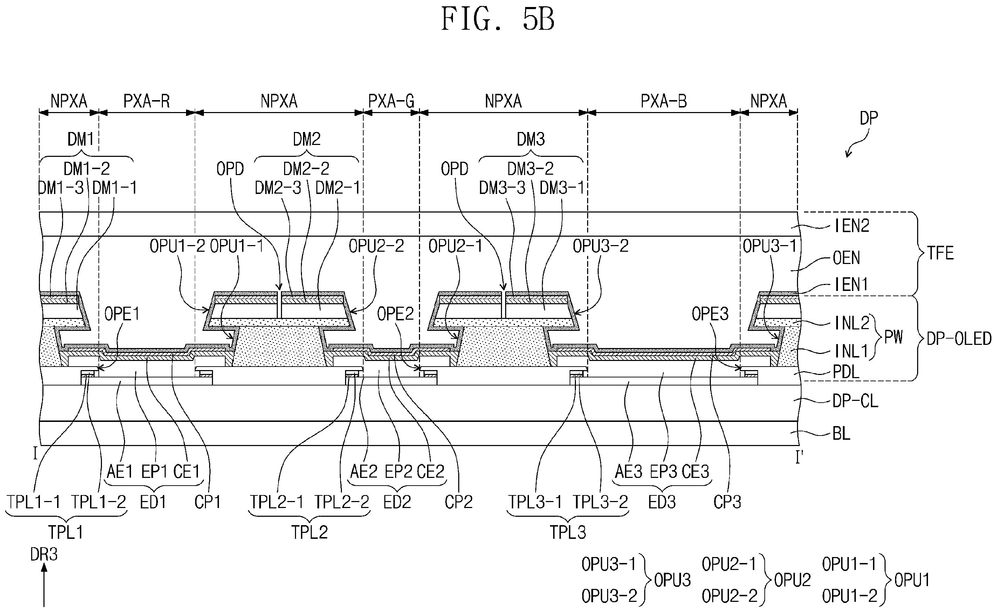

FIGS. 5A and 5B are cross-sectional views of a display panel according to embodiments of the invention. FIGS. 5A and 5B are cross-sectional views of a display panel DP taken along line I-I' of FIG. 4 according to embodiments of the invention. Particularly, FIGS. 5A and 5B may each be a cross section illustrating the adjacent first to third light-emitting regions PXA-R, PXA-G, and PXA-B and the non-light-emitting region NPXA surrounding the first to third light-emitting regions PXA-R, PXA-G, and PXA-B as illustrated in FIG. 4. The first to third light-emitting regions PXA-R, PXA-G, and PXA-B may respectively correspond to regions where light provided from light-emitting elements ED1, ED2, and ED3 is emitted.

Referring to FIGS. 5A and 5B, an embodiment of the display panel DP may include a base layer BL, a circuit element layer DP-CL, a display element layer DP-OLED, and an encapsulation layer TFE.

The display panel DP may include a plurality of insulating layers, semiconductor patterns, conductive patterns, signal lines, and the like. The insulating layer, the semiconductor layer, and the conductive layer are formed by coating, depositing and the like. Thereafter, the insulating layer, the semiconductor layer, and the conductive layer may be selectively patterned by performing photolithography and etching. The semiconductor pattern, the conductive pattern, the signal line, and the like included in the circuit element layer DP-CL and the display element layer DP-OLED are formed through such a process.

FIGS. 5A and 5B illustrate the circuit element layer DP-CL as a single layer, but this is simply illustrated for ease of illustration and description. The circuit element layer DP-CL may include an insulating layer, a semiconductor pattern, a conductive pattern, and the like to form various types of elements.

The pixel driving circuit within the circuit element layer DP-CL may be provided in plurality. The pixel driving circuits may be respectively connected to the light-emitting elements ED1, ED2, and ED3, and independently control the light-emitting elements ED1, ED2, and ED3. The pixel driving circuits may each include a plurality of transistors for driving a connected light-emitting element, at least one capacitor, and signal lines for connection thereof.

The display element layer DP-OLED may include the light-emitting elements ED1, ED2, and ED3, protection patterns TPL1, TPL2, and TPL3, pixel-defining films PDL, a conductive partition wall PW, and dummy patterns DM1, DM2, and DM3. In addition, the display element layer DP-OLED may further include capping patterns CP1, CP2, and CP3.

The light-emitting elements ED1, ED2, and ED3 may include a first light-emitting element ED1, a second light-emitting element ED2, and a third light-emitting element ED3. The first to third light-emitting elements ED1, ED2, and ED3 may respectively include lower electrodes AE1, AE2, and AE3, upper electrodes CE1, CE2, and CE3, and light-emitting patterns EP1, EP2, and EP3 disposed between the lower electrodes AE1, AE2, and AE3 and the upper electrodes CE1, CE2, and CE3. The lower electrodes AE1, AE2, and AE3 according to an embodiment may correspond to anodes, and the upper electrodes CE1, CE2, and CE3 may correspond to cathodes. However, an embodiment of the invention is not limited thereto, and alternatively, the lower electrodes AE1, AE2, and AE3 may be cathodes, and the upper electrodes CE1, CE2, and CE3 may be anodes based on a direction in which light is emitted.

In an embodiment, the first light-emitting element ED1 may include the first lower electrode AE1, the first light-emitting pattern EP1, and the first upper electrode CE1. The second light-emitting element ED2 may include the second lower electrode AE2, the second light-emitting pattern EP2, and the second upper electrode CE2. The third light-emitting element ED3 may include the third lower electrode AE3, the third light-emitting pattern EP3, and the third upper electrode CE3.

The first to third lower electrodes AE1, AE2, and AE3 may be provided as or defined by a plurality of patterns. The first to third lower electrodes AE1, AE2, and AE3 may have conductivity. In an embodiment, for example, as long they have conductivity, the lower electrodes AE1, AE2, and AE3 may each include or be formed from at least one selected from various materials such as a metal, a transparent conductive oxide, or a conductive polymer. In an embodiment, for example, the metal may include gold (Au), silver (Ag), aluminium (Al), magnesium (Mg), lithium (Li), molybdenum (Mo), copper (Cu), or an alloy. In an embodiment, for example, the transparent conductive oxide may include indium tin oxide (ITO), indium zinc oxide (IZO), zinc oxide, indium oxide, indium gallium oxide, or aluminium zinc oxide.

The first to third lower electrodes AE1, AE2, and AE3 may each have a single- or multi-layered structure. In an embodiment, for example, the first to third lower electrodes AE1, AE2, and AE3 may each have a multi-layered structure. In addition, at least one among the first to third lower electrodes AE1, AE2, and AE3 may have a multi-layered structure, the others among the first to third lower electrodes AE1, AE2, and AE3 may have a single-layered structure. However, an embodiment of the invention is not limited thereto.

The first to third light-emitting patterns EP1, EP2, and EP3 may be respectively disposed on corresponding lower electrodes among the first to third lower electrodes AE1, AE2, and AE3. In an embodiment, for example, the first light-emitting pattern EP1 may be disposed on the first lower electrode AE1, the second light-emitting pattern EP2 may be disposed on the second lower electrode AE2, and the third light-emitting pattern EP3 may be disposed on the third lower electrode AE3. In an embodiment, the first light-emitting pattern EP1 may provide (or generate) red light, the second light-emitting pattern EP2 may provide green light, and the third light-emitting pattern EP3 may provide blue light.

The first to third light-emitting patterns EP1, EP2, and EP3 may each include a light-emitting layer including a light-emitting material. The first to third light-emitting patterns EP1, EP2, and EP3 may each further include a hole injection layer and/or a hole transport layer disposed between the corresponding lower electrode among the first to third lower electrodes AE1, AE2, and AE3, and the light-emitting layer. In addition, the first to third light-emitting patterns EP1, EP2, and EP3 may each further include an electron transport layer and/or an electron injection layer disposed between the corresponding upper electrode among the first to third upper electrodes CE1, CE2, and CE3, and the light-emitting layer.

The first light-emitting pattern EP1, the second light-emitting pattern EP2, and the third light-emitting pattern EP3 may be patterned and be respectively disposed in a first light-emitting opening OPE1, a second light-emitting opening OPE2, and a third light-emitting opening OPE3 defined in the pixel-defining films PDL. In addition, the first light-emitting pattern EP1, the second light-emitting pattern EP2, and the third light-emitting pattern EP3 may be respectively disposed inside a first partition wall opening OPU1, a second partition wall opening OPU2, and a third partition wall opening OPU3 which are defined in the conductive partition wall PW. The first to third partition wall openings OPU1, OPU2, and OPU3 may include first to third lower openings OPU1-1, OPU2-1, and OPU3-1 and first to third upper openings OPU1-2, OPU2-2, and OPU3-2.

In an embodiment, for example, the first light-emitting pattern EP1, the second light-emitting pattern EP2, and the third light-emitting pattern EP3 may be respectively disposed inside the first lower opening OPU1-1, the second lower opening OPU2-1, and the third lower opening OPU3-1 defined by a first conductive layer INL1 of the conductive partition wall PW. Accordingly, at least a position of the upper surface of the pixel-defining film PDL exposed at each of the first to third lower openings OPU1-1, OPU2-1, and OPU3-1 may not be covered by the first conductive layer INL1 but be covered by the first light-emitting pattern EP1, the second light-emitting pattern EP2, and the third light-emitting pattern EP3.

FIGS. 5A and 5B illustrate embodiments where an upper surface of the pixel-defining film PDL exposed by each of the first lower opening OPU1-1, the second lower opening OPU2-1, and the third lower opening OPU3-1 is partially covered by the first light-emitting pattern EP1, the second light-emitting pattern EP2, and the third light-emitting pattern EP3, but an embodiment of the invention is not limited thereto. Alternatively, the upper surface of the exposed portions of pixel-defining film PDL by the first lower opening OPU1-1, the second lower opening OPU2-1, and the third lower opening OPU3-1 may be fully or entirely covered by the first light-emitting pattern EP1, the second light-emitting pattern EP2, and the third light-emitting pattern EP3.

The first to third upper electrodes CE1, CE2, and CE3 may be respectively disposed on corresponding light-emitting patterns among the first to third light-emitting patterns EP1, EP2, and EP3. In an embodiment, for example, the first upper electrode CE1 may be disposed on the first light-emitting pattern EP1, the second upper electrode CE2 may be disposed on the second light-emitting pattern EP2, and the third upper electrode CE3 may be disposed on the third light-emitting pattern EP3.

The first upper electrode CE1, the second upper electrode CE2, and the third upper electrode CE3 may be patterned and respectively disposed inside the first partition wall opening OPU1, the second partition wall opening OPU2, and the third partition wall opening OPU3 defined by the conductive partition wall PW. In an embodiment, for example, the first upper electrode CE1, the second upper electrode CE2, and the third upper electrode CE3 may be respectively disposed in the first lower opening OPU1-1, the second lower opening OPU2-1, and the third lower opening OPU3-1 defined by a first conductive layer INL1 of the conductive partition wall PW. Accordingly, at least a portion, not covered by the first conductive layer INL1, of the upper surface of the pixel-defining film PDL exposed by each of the first to third lower openings OPU1-1, OPU2-1, and OPU3-1, may be covered by the first to third upper electrodes CE1, CE2, and CE3. In an embodiment, for example, as illustrated in FIGS. 5A and 5B, the first upper electrode CE1, the second upper electrode CE2, and the third upper electrode CE3 may cover a portion, not covered by the first to third light-emitting patterns EP1, EP2, and EP3, of the upper surface of the pixel-defining film PDL exposed by each of the first lower opening OPU1-1, the second lower opening OPU2-1, and the third lower opening OPU3-1.

The first to third upper electrodes CE1, CE2, and CE3 may each be in contact with at least a portion of a side surface of the conductive partition wall PW. In an embodiment, for example, the first upper electrode CE1 may be in direct contact with at least a portion of a side surface of the first conductive layer INL1 defining the first lower opening OPU1-1. The second upper electrode CE2 may be in direct contact with at least a portion of a side surface of the first conductive layer INL1 defining the second lower opening OPU2-1 defined therein. The third upper electrode CE3 may be in direct contact with at least a portion of a side surface of the first conductive layer INL1 defining the third lower opening OPU3-1 defined therein. Accordingly, the first to third upper electrodes CE1, CE2, and CE3 may each be electrically connected to the first conductive layer INL1 and receive a bias voltage via the first conductive layer INL1.

In a case where an upper electrode is a common layer overlapping all of the first to third light-emitting patterns, lateral leakage current through the common layer may occur. Since the first to third upper electrodes CE1, CE2, and CE3 according to an embodiment of the invention are respectively provided at intervals on the first to third light-emitting patterns EP1, EP1, and EP3 which are spaced apart from each other, it is possible to prevent the occurrence of lateral leakage current which may occur when the upper electrode is provided as a common layer. In addition, since the upper electrodes CE1, CE2, and CE3 are electrically connected to the first conductive layer INL1 having a relatively greater thickness, driving resistances of the first to third light-emitting elements ED1, ED2, and ED3 are reduced, so that luminous efficiency may be enhanced, and a lifespan may be increased.

According to an embodiment of the invention, the display panel DP may include protection patterns TPL1, TPL2, and TPL3. The protection patterns TPL1, TPL2, and TPL3 may include the first protection pattern TPL1 disposed on an upper surface of the first lower electrode AE1, the second protection pattern TPL2 disposed on an upper surface of the second lower electrode AE2, and the third protection pattern TPL3 disposed on an upper surface of the third lower electrode AE3. Upper surfaces of the protection patterns TPL1, TPL2, and TPL3 may be covered by the pixel-defining film PDL. The protection patterns TPL1, TPL2, and TPL3 may respectively expose at least a portion of the corresponding lower electrodes AE1, AE2, and AE3. The protection patterns TPL1, TPL2, and TPL3 may be disposed between portions of the pixel-defining film PDL and portions of the lower electrodes AE1, AE2, and AE3, which overlap each other. The protection patterns TPL1, TPL2, and TPL3 may be respectively disposed not to overlap the light-emitting openings OPE1, OPE2, and OPE3.

The first to third lower electrodes AE1, AE2, and AE3 may be spaced apart from the pixel-defining film PDL in the third direction DR3 with the protection patterns TPL1, TPL2, and TPL3 therebetween. Since the protection patterns TPL1, TPL2, and TPL3 are disposed on the first to third lower electrodes AE1, AE2, and AE3 during a manufacturing process, it is possible to prevent the first to third lower electrodes AE1, AE2, and AE3 from being damaged during an etching process of forming the light-emitting openings OPE1, OPE2, and OPE3 in the pixel-defining film PDL.

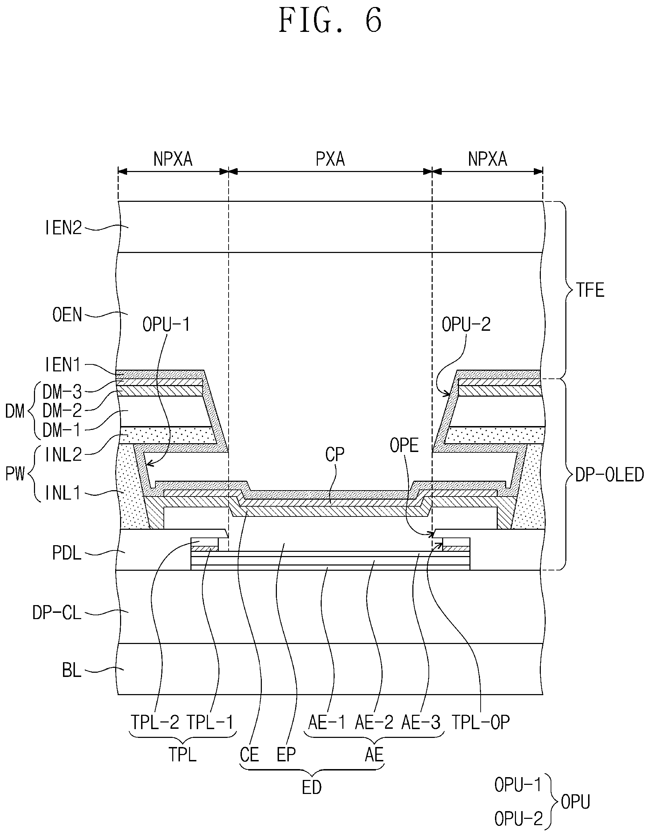

In an embodiment, the protection patterns TPL1, TPL2, and TPL3 may respectively include a plurality of layers stacked in a thickness direction of the display panel DP. In an embodiment, for example, the protection patterns TPL1, TPL2, and TPL3 may respectively include first layers TPL1-1, TPL2-1, and TPL3-1 and second layers TPL1-2, TPL2-2, and TPL3-2. The first layers TPL1-1, TPL2-1, and TPL3-1 may be disposed on the corresponding lower electrodes AE1, AE2, and AE3, and the second layers TPL1-2, TPL2-2, and TPL3-2 may be disposed on the corresponding first layers TPL1-1, TPL2-1, and TPL3-1. In an embodiment, for example, the first protection pattern TPL1 may include a first first layer (hereinafter, will be referred to as "(1-1)-th layer") TPL1-1 disposed on the first lower electrode AE1 and a second first layer (hereinafter, will be referred to as "(1-2)-th layer") TPL1-2 disposed on the (1-1)-th layer TPL1-1. The second protection pattern TPL2 may include a first second layer (hereinafter, will be referred to as "(2-1)-th layer") TPL2-1 disposed on the second lower electrode AE2 and a second second layer (hereinafter, will be referred to as "(2-2)-th layer") TPL2-2 disposed on the (2-1)-th layer TPL2-1. The third protection pattern TPL3 may include a first third layer (hereinafter, will be referred to as "(3-1)-th layer") TPL3-1 disposed on the third lower electrode AE3 and a second third layer (hereinafter, will be referred to as "(3-2)-th layer") TPL3-2 disposed on the (3-1)-th layer TPL3-1. The protection patterns TPL1, TPL2, and TPL3 will be described later in greater detail with the reference to FIG. 6.

The pixel-defining film PDL may be disposed on the circuit element layer DP-CL. The first to third light-emitting openings OPE1, OPE2, and OPE3 may be defined in the pixel-defining film PDL. The first to third light-emitting openings OPE1, OPE2, and OPE3 may respectively correspond to the first to third lower electrodes AE1, AE2, and AE3. The pixel-defining film PDL may expose at least a portion of each of the first to third lower electrodes AE1, AE2, and AE3 through the light-emitting openings OPE1, OPE2, and OPE3. The pixel-defining film PDL may overlap, on a plane, the protection patterns TPL1, TPL2, and TPL3 disposed on the upper surfaces of the first to third lower electrodes AE1, AE2, and AE3.

The first light-emitting region PXA-R may be defined as a region, exposed by the first light-emitting opening OPE1, in the upper surface of the first lower electrode AE1, the second light-emitting region PXA-G may be defined as a region, exposed by the second light-emitting opening OPE2, in the upper surface of the second lower electrode AE2, and the third light-emitting region PXA-B may be defined as a region, exposed by the third light-emitting opening OPE3, in the upper surface of the third lower electrode AE3.

The pixel-defining film PDL may be an inorganic insulating film. In an embodiment, for example, the pixel-defining film PDL may include a silicon oxide, a silicon nitride, or a combination thereof. In an embodiment, for example, the pixel-defining film PDL may have a single-layered structure of a silicon oxide layer or a silicon nitride layer. Also, the pixel-defining film PDL may have a two-layered structure in which a silicon oxide layer and a silicon nitride layer are sequentially stacked. However, these are merely examples, the material or number of layers of the pixel-defining film PDL may be variously modified as long as the pixel-defining film PDL is an inorganic insulating film, and is not limited to any one embodiment. The pixel-defining film PDL may be disposed between the first to third lower electrodes AE1, AE2, and AE3 and the conductive partition wall PW, and may block the first to third lower electrodes AE1, AE2, and AE3 from being electrically connected to the conductive partition wall PW.

The conductive partition wall PW is disposed on the pixel-defining film PDL. The first to third partition wall openings OPU1, OPU2, and OPU3 may be defined in the conductive partition wall PW. The first to third partition wall openings OPU1, OPU2, and OPU3 may respectively correspond to the first to third light-emitting openings OPE1, OPE2, and OPE3. The first to third partition wall openings OPU1, OPU2, and OPU3 may respectively expose at least a portion of the corresponding lower electrodes AE1, AE2, and AE3.

The conductive partition wall PW may include the first conductive layer INL1 and the second conductive layer INL2. The first conductive layer INL1 may be disposed on the pixel-defining film PDL, and the second conductive layer INL2 may be disposed on the first conductive layer INL1. The thickness of the first conductive layer INL1 may be greater than the thickness of the second conductive layer INL2.

On a plane, an inner surface of the second conductive layer INL2 may be more adj acent to a center of a corresponding one of the first to third lower electrodes AE1, AE2, and AE3 than an inner surface of the first conductive layer INL1 is. A portion in the second conductive layer INL2, which is more adjacent to a center of the corresponding one of the first to third lower electrodes AE1, AE2, and AE3 than a side surface of the first conductive layer INL1 is, may be defined as a tip-portion of the conductive partition wall PW. The light-emitting patterns EP1, EP2, and EP3 may be separated by the tip-portion of the conductive partition wall PW and be formed inside the respective light-emitting openings OPE1, OPE2, and OPE3 and inside the respective partition wall openings OPU1, OPU2, and OPU3, and the upper electrodes CE1, CE2, and CE3 may be separated by the tip-portion of the conductive partition wall PW and be formed inside the respective partition wall openings OPU1, OPU2, and OPU3.

The first lower opening OPU1-1, the second lower opening OPU2-1, and the third lower opening OPU3-1 may be defined in the first conductive layer INL1. The first upper opening OPU1-2, the second upper opening OPU2-2, and the third upper opening OPU3-2 may be defined in the second conductive layer INL2. The first upper opening OPU1-2, the second upper opening OPU2-2, and the third upper opening OPU3-2 may respectively correspond to the first light-emitting opening OPE1, the second light-emitting opening OPE2, and the third light-emitting opening OPE3.

The planar areas of the first lower opening OPU1-1, the second lower opening OPU2-1, and the third lower opening OPU3-1 may be respectively greater than the planar areas of the first upper opening OPU1-2, the second upper opening OPU2-2, and the third upper opening OPU3-2. Also, the planar areas of the first lower opening OPU1-1, the second lower opening OPU2-1, and the third lower opening OPU3-1 may be respectively greater than the planar areas of the first light-emitting opening OPE1, the second light-emitting opening OPE2, and the third light-emitting opening OPE3.

In an embodiment, as illustrated in FIG. 5A, the planar areas of the first upper opening OPU1-2, the second upper opening OPU2-2, and the third upper opening OPU3-2 may be substantially the same as the planar areas of the first light-emitting opening OPE1, the second light-emitting opening OPE2, and the third light-emitting opening OPE3, respectively. However, an embodiment of the invention is not limited thereto, and the first to third upper openings OPU1-2, OPU2-2, and OPU3-2 may have different planar areas from the corresponding first to third light-emitting openings OPE1, OPE2, and OPE3, respectively. In an alternative embodiment, for example, as illustrated in FIG. 5B, the first upper opening OPU1-2, the second upper opening OPU2-2, and the third upper opening OPU3-2 may have greater planar areas than the first light-emitting opening OPE1, the second light-emitting opening OPE2, and the third light-emitting opening OPE3, respectively.

The first conductive layer INL1 and the second conductive layer INL2 may each include an inorganic material. The first conductive layer INL1 and the second conductive layer INL2 may each include a conductive metal. In an embodiment, for example, the first conductive layer INL1 may include aluminium (Al) or molybdenum (Mo), and the second conductive layer INL2 may include titanium (Ti). However, materials included in the first and second conductive layers INL1 and INL2 are not limited thereto.

The etch rate of the first conductive layer INL1 may be higher than the etch rate of the second conductive layer INL2 during an etching process of forming the conductive partition wall PW. That is, the first conductive layer INL1 may include a material having higher etching selectivity than the second conductive layer INL2. The second conductive layer INL2 may include a material having lower reflectivity than the first conductive layer INL1. In an embodiment, the first conductive layer INL1 may include aluminium (Al), and the second conductive layer INL2 may include titanium (Ti). Since the second conductive layer INL2 forms an upper portion of the conductive partition wall PW, the reflectance on an upper surface of the conductive partition wall PW is reduced and thus the display quality of the display panel DP may be improved.

According to an embodiment of the invention, the plurality of first to third light-emitting patterns EP1, EP2, and EP3 may be patterned and deposited in each pixel through a tip-portion defined in the conductive partition wall PW. In an embodiment, for example, the light-emitting patterns EP1, EP2, EP3 are formed in common by using an open mask, but may be easily divided into each pixel unit due to the conductive partition wall PW.

Since the display panel DP according to an embodiment includes the conductive partition wall PW, physical separation between the light-emitting elements ED1, ED2, and ED3 may be easily provided. Accordingly, current leakage, driving errors, or the like between the adjacent light-emitting regions PXA-R, PXA-G, and PXA-B are prevented, so that the light-emitting elements ED1, ED2, and ED3 may be each independently driven.

In such an embodiment, since the plurality of first to third light-emitting patterns EP1, EP2, and EP3 are patterned without a mask in contact with internal components in the display region DA (see FIG. 2), a defect rate is reduced, and thus, the display panel DP having improved process reliability may be obtained. Even when an additional spacer support protruding from the conductive partition wall PW is not provided, a patterning process may be effectively performed. Therefore, the areas of the light-emitting regions PXA-R, PXA-G, and PXA-B may be reduced and thus, the display panel DP easily achieving a high-resolution display may be provided.

The capping patterns CP1, CP2, and CP3 may be respectively disposed inside (or not to overlap) the first to third partition wall openings OPU1, OPU2, and OPU3 and disposed on the first to third upper electrodes CE1, CE2, and CE3. In an embodiment, for example, the capping patterns CP1, CP2, and CP3 may include a first capping pattern CP1 disposed on the first upper electrode CE1, a second capping pattern CP2 disposed on the second upper electrode CE2, and a third capping pattern CP3 disposed on the third upper electrode CE3. The first capping pattern CP1 may be disposed inside the first lower opening OPU1-1, the second capping pattern CP2 may be disposed inside the second lower opening OPU2-1, and the third capping pattern CP3 may be disposed inside the third lower opening OPU3-1. The first to third capping patterns CP1, CP2, and CP3 may be each covered by a first inorganic encapsulation film IEN1 to be described later. In some embodiments, the capping patterns CP1, CP2, and CP3 may be omitted.

The capping patterns CP1, CP2, and CP3 may have a single-layer structure or a multi-layer structure. The capping patterns CP1, CP2, and CP3 may be an inorganic layer or an organic layer. In an embodiment, for example, where the capping patterns CP1, CP2, and CP3 include an inorganic material, the inorganic material may include an alkali metal compound such as LiF, an alkaline earth metal compound such as MgF₂ SiON, SiNₓ, SiO_{y}, or the like. In an embodiment, for example, where the capping patterns CP1, CP2, and CP3 include an organic material, the organic material may include α-NPD, NPB, TPD, m-MTDATA, Alq₃, CuPc, TPD15 (N4,N4,N4',N4'-tetra(biphenyl-4-yl)biphenyl-4,4'-diamine), TCTA (4,4',4"-tris(carbazol-9-yl)triphenylamine), or the like or include an epoxy resin or an acrylate such as a methacrylate.

The capping patterns CP1, CP2, and CP3 may function as a buffer layer that protects the light-emitting elements ED1, ED2, and ED3, and the like, disposed therebelow. The capping patterns CP1, CP2, and CP3 may have a refractive index of about 1.6 or greater. In an embodiment, for example, the capping patterns CP1, CP2, and CP3 may have a refractive index of about 1.9. In such an embodiment where the capping patterns CP1, CP2, and CP3 have a refractive index of about 1.9, light extraction efficiency of the display element layer DP-OLED may be improved.

The dummy patterns DM1, DM2, and DM3 may be disposed on the conductive partition wall PW. The dummy patterns DM1, DM2, and DM3 may include a first dummy pattern DM1, a second dummy pattern DM2, and a third dummy pattern DM3.

The first dummy pattern DM1 may include a first first dummy pattern (hereinafter, will be referred to as "(1-1)-th dummy pattern") DM1-1, a second first dummy pattern (hereinafter, will be referred to as "(1-2)-th dummy pattern") DM1-2, and a third first dummy pattern (hereinafter, will be referred to as "(1-3)-th dummy pattern") DM1-3 which are sequentially stacked. The (1-1)-th dummy pattern DM1-1 may include a light-emitting material the same as the first light-emitting pattern EP1. The (1-2)-th dummy pattern DM1-2 may include an electrode material the same as the first upper electrode CE1. The (1-3)-th dummy pattern DM1-3 may include a capping material same as the first capping pattern CP1.

The second dummy pattern DM2 may include a first second dummy pattern (hereinafter, will be referred to as "(2-1)-th dummy pattern") DM2-1, a second second dummy pattern (hereinafter, will be referred to as "(2-2)-th dummy pattern") DM2-2, and a third second dummy pattern (hereinafter, will be referred to as "(2-3)-th dummy pattern") DM2-3 which are sequentially stacked. The (2-1)-th dummy pattern DM2-1 may include a light-emitting material the same as that of the second light-emitting pattern EP2. The (2-2)-th dummy pattern DM2-2 may include an electrode material the same as that of the second upper electrode CE2. The (2-3)-th dummy pattern DM2-3 may include a capping material the same as that of the second capping pattern CP2.

The third dummy pattern DM3 may include a first third dummy pattern (hereinafter, will be referred to as "(3-1)-th dummy pattern") DM3-1, a second third dummy pattern (hereinafter, will be referred to as "(3-2)-th dummy pattern") DM3-2, and a third third dummy pattern (hereinafter, will be referred to as "(3-3)-th dummy pattern") DM3-3 which are sequentially stacked. The (3-1)-th dummy pattern DM3-1 may include a light-emitting material the same as that of the third light-emitting pattern EP3. The (3-2)-th dummy pattern DM3-2 may include an electrode material the same as that of the third upper electrode CE3. The (3-3)-th dummy pattern DM3-3 may include a capping material the same as that of the third capping pattern CP3.

The dummy patterns DM1, DM2, and DM3 may each cover a portion of an upper surface of the conductive partition wall PW. In an embodiment, for example, the first dummy pattern DM1 and the second dummy pattern DM2 may be disposed to be spaced apart from each other on the conductive partition wall PW between the first light-emitting region PXA-R and the second light-emitting region PXA-G adjacent thereto. Also, the second dummy pattern DM2 and the third dummy pattern DM3 may be disposed to be spaced apart from each other on the conductive partition wall PW between the second light-emitting region PXA-G and the third light-emitting region PXA-B adjacent thereto. Further, the third dummy pattern DM3 and the first dummy pattern DM1 may be disposed to be spaced apart from each other on the conductive partition wall PW between the third light-emitting region PXA-B and the first light-emitting region PXA-R adjacent thereto. Accordingly, dummy openings OPD may be respectively defined through the first dummy pattern DM1 and the second dummy pattern DM2, through the second dummy pattern DM2 and the third dummy pattern DM3, and through the first dummy pattern DM1 and the third dummy pattern DM3. The dummy opening OPD may be filled with an organic encapsulation film OEN to be described later.

The encapsulation layer TFE may be disposed on the display element layer DP-OLED. The encapsulation layer TFE may cover the light-emitting elements ED1, ED2, and ED3. The encapsulation layer TFE may seal the display element layer DP-OLED. The encapsulation layer TFE may be a thin-film encapsulation layer. The encapsulation layer TFE may be a single layer or have a stacked structure of a plurality of layers. The encapsulation layer TFE may include at least one insulating layer.

The encapsulation layer TFE may include at least one inorganic film and at least one organic film. In an embodiment, for example, the encapsulation layer TFE may include a first inorganic encapsulation film IEN1, an organic encapsulation film OEN, and a second inorganic encapsulation film IEN2. However, this is merely an example, but layers constituting the encapsulation layer TFE is not limited thereto.

The first inorganic encapsulation film IEN1 and the second inorganic encapsulation film IEN2 may protect the display element layer DP-OLED against moisture and oxygen. The first inorganic encapsulation film IEN1 and the second inorganic encapsulation film IEN2 may include silicon nitride, silicon oxynitride, silicon oxide, titanium oxide, or aluminium oxide, or the like, but are not particularly limited thereto.

The organic encapsulation film OEN may protect the display element layer DP-OLED against foreign substances such as dust particles. The organic encapsulation film OEN may include an acrylic compound, an epoxy-based compound, or the like. The organic encapsulation film OEN may include a photopolymerizable organic material, but is not particularly limited thereto. The organic encapsulation film OEN may fill the dummy opening OPD and seal the dummy opening OPD.

FIG. 6 is an enlarged cross-sectional view of a region of a display panel according to an embodiment of the invention. FIG. 6 is an enlarged cross-sectional view illustrating one light-emitting region PXA and a non-light-emitting region NPXA adjacent thereto in the display panel DP. In an embodiment, the light-emitting regions PXA illustrated in FIG. 6 may respectively correspond to the first to third light-emitting regions PXA-R, PXA-G, and PXA-B illustrated in FIGS. 5A and 5B. A description of a light-emitting region PXA to be described later may be applied to all the first to third light-emitting regions PXA-R, PXA-G, and PXA-B described with reference to FIGS. 5A and 5B. Hereinafter, in the description of FIG. 6, any repetitive detailed description of the same components as those described with the references to FIGS. 5A and 5B will be omitted.

Referring to FIG. 6, the display panel DP according to an embodiment of the invention may include a base layer BL, a circuit element layer DP-CL disposed on the base layer BL, a display element layer DP-OLED disposed on the circuit element layer DP-CL, and an encapsulation layer TFE disposed on the display element layer DP-OLED. The display element layer DP-OLED may include a light-emitting element ED, a pixel-defining film PDL, a conductive partition wall PW, a capping pattern CP, and a dummy pattern DM. The light-emitting element ED includes a lower electrode AE (or anode), a light-emitting pattern EP, an upper electrode CE (or cathode), and may further include a capping pattern CP. In some embodiments, the capping pattern CP may be omitted. The encapsulation layer TFE may include a first inorganic encapsulation film IEN1, an organic encapsulation film OEN, and a second inorganic encapsulation film IEN2.

In an embodiment, the light-emitting element ED may include the lower electrode AE having a multi-layered structure. In an embodiment, for example, the lower electrode AE may include a first sub-layer AE-1, a second sub-layer AE-2, and a third sub-layer AE-3. FIG. 6 illustrates an embodiment where the lower electrode AE has a three-layered structure, but an embodiment of the invention is not limited thereto. Alternatively, the lower electrode AE may have a two-layered structure. In an embodiment, for example, the lower electrode AE may include the second sub-layer AE-2 and the third sub-layer AE-3. The lower electrodes AE may correspond to the first to third lower electrodes AE1, AE2, and AE3 illustrated in FIGS. 5A and 5B.

The first sub-layer AE-1 may be disposed on the circuit element layer DP-CL. The first sub-layer AE-1 may be directly disposed on the circuit element layer DP-CL. The first sub-layer AE-1 may include a transparent conductive oxide. In an embodiment, for example, the first sub-layer AE-1 may be a transparent layer including indium tin oxide (ITO).

The second sub-layer AE-2 may be disposed on the first sub-layer AE-1. In some embodiments, where the first sub-layer AE-1 is omitted, the second sub-layer AE-2 may be directly disposed on an upper surface of the circuit element layer DP-CL. The second sub-layer AE-2 may include a metal material. In an embodiment, for example, the second sub-layer AE-2 may be a reflective layer formed from silver (Ag), Ag-containing alloy, or the like.

The third sub-layer AE-3 may be disposed on the second sub-layer AE-2. The third sub-layer AE-3 and the first sub-layer AE-1 may include the same material as each other, or include different materials from each other. In an embodiment, for example, the third sub-layer AE-3 may be a transparent layer including indium tin oxide (ITO).

In an embodiment, the lower electrode AE may have a multi-layered structure in which the first sub-layer AE-1 including indium tin oxide (ITO), the second sub-layer AE-2 including silver (Ag), and the third sub-layer AE-3 including indium tin oxide (ITO) are stacked sequentially. That is, the lower electrode AE may have a stacked structure of ITO/Ag/ITO. However, an embodiment of the invention is not limited thereto, and the lower electrode AE may have a stacked structure of Ag/ITO in which the first sub-layer AE-1 is omitted, and the second sub-layer AE-2 and the third sub-layer AE-3 are included.

According to an embodiment of the invention, a protection pattern TPL is disposed on the lower electrode AE. The protection pattern TPL may respectively correspond to the first to third protection patterns TPL1, TPL2, and TPL3 illustrated in FIGS. 5A and 5B.

The protection pattern TPL is disposed on the lower electrode AE. The protection pattern TPL includes the first layer TPL-1 and the second layer TPL-2. The second layer TPL-2 includes a transparent conductive oxide to protect the lower electrode AE against damage caused during the process of forming the light-emitting opening OPE. In an embodiment, for example, the second layer TPL-2 may include indium zinc oxide (IZO), zinc oxide (ZnO), or indium gallium zinc oxide (IGZO). In an embodiment, the second layer TPL-2 may include indium zinc oxide (IZO) or indium gallium zinc oxide (IGZO) which has an amorphous form even during a thermal process.

In a case, where the second layer TPL-2 of an IZO layer or an IGZO layer is directly disposed on the lower electrode AE, zinc is diffused to the lower electrode AE to increase driving voltage, thereby causing deterioration of an electronic element. The protection pattern TPL according to an embodiment includes the first layer TPL-1 which prevents the lower electrode AE from contacting the second layer TPL-2 between the lower electrode AE and the second layer TPL-2, thereby effectively preventing deterioration of the electronic element.

In an embodiment, the first layer TPL-1 may be directly disposed on an upper surface of the lower electrode AE. The second layer TPL-2 may be directly disposed on an upper surface of the first layer TPL-1 and not be in contact with the lower electrode AE. In an embodiment, for example, the first layer TPL-1 may be in direct contact with the third sub-layer AE-3 of the lower electrode AE, and the second layer TPL-2 may be not in contact with the third sub-layer AE-3 of the lower electrode AE. That is, the first layer TPL-1 may be a separation layer to prevent diffusion of zinc, included in the second layer TPL-2, into the lower electrode AE.

The first layer TPL-1 may include a material that may be easily removed during the process of forming the light-emitting opening OPE. According to the invention, the first layer TPL-1 includes molybdenum tantalum oxide (MoTaOₓ). Accordingly, the first layer TPL-1 and the second layer TPL-2 may be collectively removed during the process of forming the light-emitting opening OPE. In addition, the first layer TPL-1 may have a relatively thin thickness to be easily removed during the process of forming the light-emitting opening OPE. The thickness of the first layer TPL-1 may be less than the thickness of the second layer TPL-2. In an embodiment, for example, the thickness of the first layer TPL-1 may be in a range of about 50 angstrom (Å) to about 200 Å. Alternatively, the first layer TPL-1 may have a thickness of in a range of about 50 Å to about 100 Å. However, an embodiment of the invention is not limited thereto.

The first layer TPL-1 may include or contain tantalum (Ta) in an amount of about 2 atomic percent (at%) or greater with respect to the total content of the first layer TPL-1. In an embodiment, for example, the first layer TPL-1 may contain tantalum (Ta) in an amount in a range of about 2 at% to about 15 at% with respect to the total content of the first layer TPL-1. If tantalum (Ta) is contained in an amount of less than about 2 at%, the solubility of MoTaOₓ in water becomes excessively high. Thus, it is highly likely that an upper layer of the lower electrode AE in contact with the first layer TPL-1 is lifted off. Therefore, the first layer TPL-1 may contain tantalum (Ta) in an amount described above.

An opening TPL-OP exposing a portion of an upper surface of the lower electrode AE is defined in the protection pattern TPL. The planar area of the opening TPL-OP defined in the protection pattern TPL may be greater than the planar area of the light-emitting opening OPE defined by the pixel-defining film PDL. That is, on a plane, an inner surface of the pixel-defining film PDL may be more adjacent to the center of the lower electrode AE than an inner surface of the protection pattern TPL is.

The conductive partition wall PW may have an undercut shape on a cross section. A side surface, of the conductive partition wall PW, defining the partition wall opening OPU may have an undercut shape on a cross section. The partition wall opening OPU may include a lower opening OPU-1 and an upper opening OPU-2.

The conductive partition wall PW may include multiple layers sequentially stacked, and at least one layer among the multiple layers may be recessed compared to layers stacked thereon. Accordingly, the conductive partition wall PW may have a tip-portion. In an embodiment, the conductive partition wall PW may include a first conductive layer INL1, and a second conductive layer INL2 disposed on the first conductive layer INL1. The lower opening OPU-1 may be defined by a side surface of the first conductive layer INL1, and the upper opening OPU-2 may be defined by a side surface of the second conductive layer INL2.

The first conductive layer INL1 may be disposed on the pixel-defining film PDL. In some embodiments, the conductive partition wall PW may further include layers disposed below the first conductive layer INL1, between the first conductive layer INL1 and the second conductive layer INL2, or on the second conductive layer INL2.

The dummy pattern DM according to an embodiment may include a first dummy layer DM-1, a second dummy layer DM-2, and a third dummy layer DM-3 which are sequentially stacked on the conductive partition wall PW. The first dummy layer DM-1 may correspond to the (1-1)-th to (3-1)-th dummy patterns DM1-1, DM2-1, and DM3-1 of FIGS. 5A and 5B. The second dummy layer DM-2 may correspond to the (1-2)-th to (3-2)-th dummy patterns DM1-2, DM2-2, and DM3-2 of FIGS. 5A and 5B. The third dummy layer DM-3 may correspond to the (1-3)-th to (3-3)-th dummy patterns DM1-3, DM2-3, and DM3-3 of FIGS. 5A and 5B.

The first dummy layer DM-1 and the light-emitting pattern EP may be formed through a same process, and thus have a same structure and include a same material as each other. The first dummy layer DM-1 may be separated from the light-emitting pattern EP by the tip-portion of the conductive partition wall PW when the light-emitting pattern EP is formed in common. An end, of the first dummy layer DM-1, heading the partition wall opening OPU may be spaced apart from the light-emitting pattern EP.

The second dummy layer DM-2 and the upper electrode CE may be formed through a same process, and thus have a same structure and include a same material as each other. The second dummy layer DM-2 may be separated from the upper electrode CE by the tip-portion of the conductive partition wall PW when the upper electrode CE is formed in common. An end, of the second dummy layer DM-2, heading the partition wall opening OPU may be spaced apart from the upper electrode CE.

The third dummy layer DM-3 and the capping pattern CP may be formed through a same process, and thus have a same structure and include a same material as each other. The third dummy layer DM-3 may be separated from the capping pattern CP by a tip-portion of the conductive partition wall PW when the capping pattern CP is formed in common. An end, of the third dummy layer DM-3, heading the partition wall opening OPU may be spaced apart from the capping pattern CP. In an embodiment, where the capping pattern CP is omitted, the third dummy layer DM-3 may also be omitted.

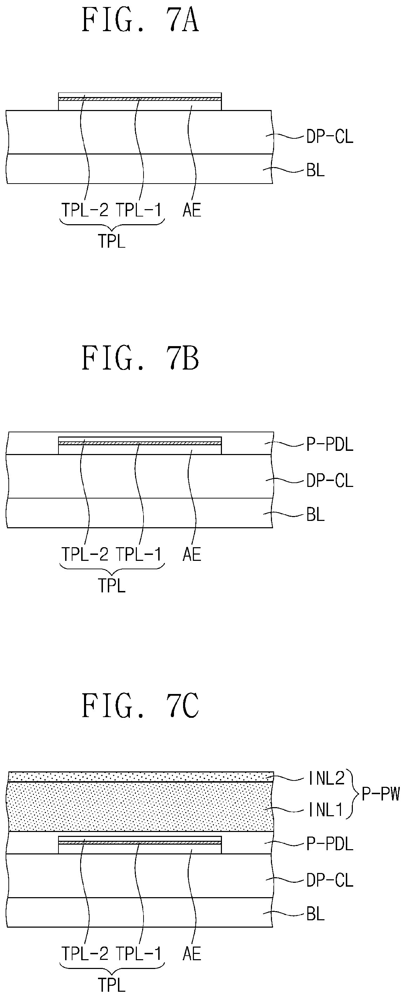

FIGS. 7A to 7C are cross-sectional views respectively illustrating some operations of a method of manufacturing a display panel according to an embodiment of the invention. FIGS. 7A to 7C are cross-sectional views respectively illustrating operations (or processes) of providing a preliminary display panel as an example.

Referring to FIG. 7A, the operation of providing the preliminary display panel according to an embodiment may include patterning a lower electrode AE and a protection pattern TPL, which are provided on a base layer BL and a circuit element layer DP-CL. In an embodiment, for example, the protection pattern TPL may be formed on the lower electrode AE. The lower electrode AE may have a stacked structure of ITO/Ag/ITO.

The protection pattern TPL may be formed by depositing, onto the lower electrode AE, molybdenum tantalum oxide (MoTaOₓ) for forming the first layer TPL-1, and depositing, onto the first layer TPL-1, indium zinc oxide (IZO) or indium gallium zinc oxide (IGZO) for forming the second layer TPL-2. In molybdenum tantalum oxide (MoTaOₓ) which forms the first layer TPL-1, x may be about 2.0 to about 3.0.

According to an embodiment of the invention, since the first layer TPL-1 is formed between the lower electrode AE and the second layer TPL-2, the second layer TPL-2 is not in contact with the lower electrode AE. Therefore, it is possible to prevent the lower electrode AE from being affected by zinc. The first layer TPL-1 may be formed to have a thickness less than that of the second layer TPL-2. In an embodiment, for example, the first layer TPL-1 may be formed to have a thickness in a range of about 50 Å to about 200 Å. The second layer TPL-2 may be formed to have a thickness in a range of about 300 Å, but an embodiment of the invention is not limited thereto.

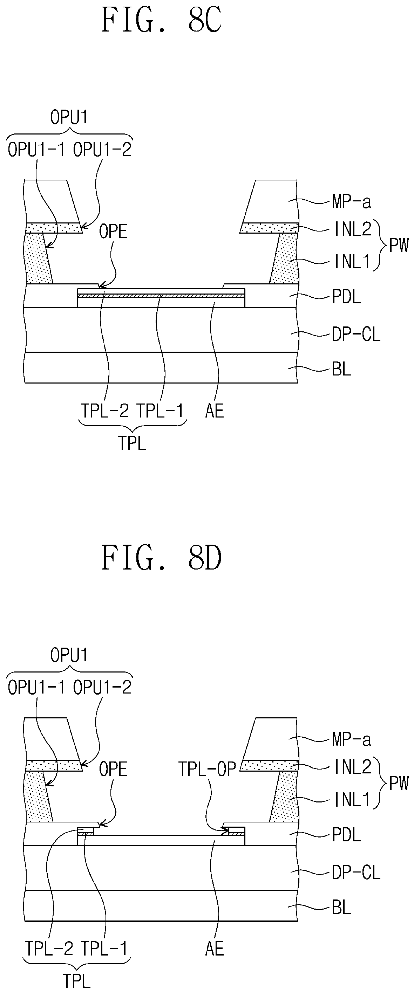

In an embodiment, the first layer TPL-1 may be directly formed on an upper surface of the lower electrode AE through a sputtering process. The first layer TPL-1 may be formed through a deposition process using targets respectively including molybdenum (Mo) and tantalum (Ta). Alternatively, the first layer TPL-1 may be formed through a deposition process using a single target including molybdenum (Mo) and tantalum (Ta). In an embodiment, for example, in the sputtering process of forming the first layer TPL-1, target materials to be sputtered may be MoOₓ and TaOₓ. In molybdenum tantalum oxide (MoTaOₓ) for forming the first layer TPL-1, oxygen atoms may be included in an amount of about 2 at% or greater, e.g., about 6 at%. In this case, the first layer TPL-1 may be easily removed using deionized (DI) water and tetramethylammonium hydroxide (TMAH). Therefore, the first layer TPL-1 and the second layer TPL-2 may be collectively removed through a single etching process and a cleaning process for the second layer TPL-2 without performing an additional etching process during the process of forming a light-emitting opening OPE (FIG. 8C) to be described later.

Referring to FIG. 7B, the operation of preparing the preliminary display panel may include forming a preliminary pixel-defining film P-PDL. The preliminary pixel-defining film P-PDL may be formed on the circuit element layer DP-CL and cover the lower electrode AE and the protection pattern TPL.

Referring to FIG. 7C, the operation of preparing the preliminary display panel may include forming a preliminary conductive partition wall P-PW. The preliminary conductive partition wall P-PW may be formed on the preliminary pixel-defining film P-PDL. The preliminary conductive partition wall P-PW may include a first conductive layer INL1 and a second conductive layer INL2. The first conductive layer INL1 may be directly formed on the preliminary pixel-defining film P-PDL, and the second conductive layer INL2 may be formed on the first conductive layer INL1. The first conductive layer INL1 may have a greater thickness than the second conductive layer INL2.

In an embodiment, the first conductive layer INL1 may include aluminium (Al), and the second conductive layer INL2 may include titanium (Ti). However, an embodiment of the invention is not limited thereto, and the second conductive layer INL2 may include an inorganic material having a second conductivity lower than a first conductivity of the first conductive layer INL1.

The preliminary display panel including the base layer BL, the circuit element layer DP-CL, the lower electrode AE, the protection pattern TPL, the preliminary pixel-defining film P-PDL, and the preliminary conductive partition wall P-PW may be prepared through the operations illustrated with reference to FIGS. 7A to 7C.

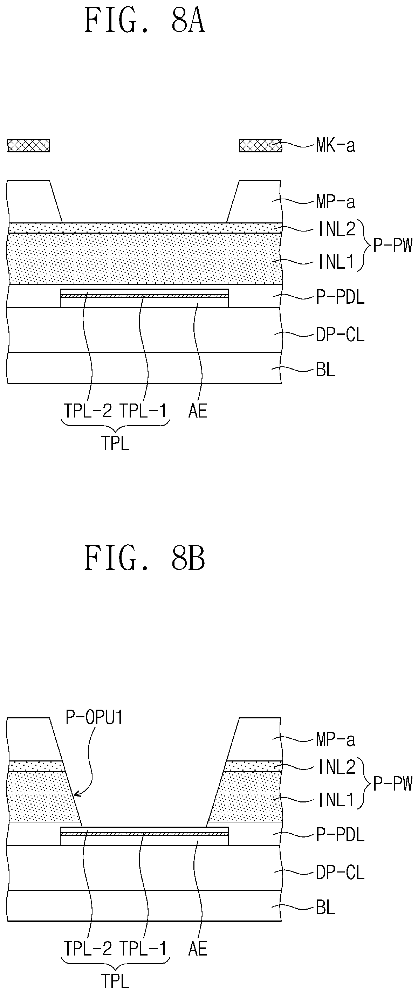

FIGS. 8A to 8D are cross-sectional views respectively illustrating some operations of a method of manufacturing a display panel according to an embodiment of the invention. FIGS. 8A to 8C are cross-sectional views respectively illustrating operations of forming a conductive partition wall and a pixel-defining film as an example, and FIG. 8D is a cross-sectional view illustrating a preliminary operation of forming a pixel region.

Referring to FIG. 8A, the operation of forming the conductive partition wall and the pixel-defining film may include forming a photomask pattern MP-a on the preliminary display panel formed through the operation of providing the preliminary display panel illustrated with reference to FIGS. 7A to 7C. The photomask pattern MP-a may be formed by using a photomask MK-a with an opening defined in a region corresponding to a lower electrode AE. In an embodiment, for example, the photomask pattern MP-a may be formed by forming a photoresist layer on a preliminary conductive partition wall P-PW, and then performing an exposure and development using the photomask MK-a.

Referring to FIG. 8B, the operation of forming the conductive partition wall PW (see FIG. 8C) may include forming a preliminary partition wall opening P-OPU1 in a preliminary conductive partition wall P-PW through a first etching process using the photomask pattern MP-a as a mask. Also, the operation of forming a pixel-defining film PDL (see FIG. 8C) may include forming a light-emitting opening OPE (see FIG. 8C) in a preliminary pixel-defining film P-PDL through the first etching process. In an embodiment, the preliminary partition wall opening P-OPU1 and the light-emitting opening OPE (see FIG. 8C) may be collectively etched through the first etching process.

In an embodiment, for example, the preliminary partition wall opening P-OPUI and the light-emitting opening OPE may be formed by dry-etching a first conductive layer INL1, a second conductive layer INL2, and a preliminary pixel-defining film P-PDL, using the photomask pattern MP-a as a mask. A protection pattern TPL may be exposed by dry-etching the preliminary pixel-defining film P-PDL and the preliminary conductive partition wall P-PW, using the photomask pattern MP-a as a mask. The protection pattern TPL may effectively prevent the lower electrode AE from being damaged during the first etching process.

In an alternative embodiment, the partition wall opening OPU1 (see FIG. 8C) is formed first in the conductive partition wall PW (see FIG. 8C), and then the light-emitting opening OPE (see FIG. 8C) may be formed in the preliminary pixel-defining film P-PDL through an additional etching process.

Referring to FIG. 8C, the operation of forming the conductive partition wall PW may include forming the partition wall opening OPUI through a second etching process. In an embodiment, for example, in the operation of forming the conductive partition wall PW, the first conductive layer INL1 and the second conductive layer INL2 may be wet-etched by using the photomask pattern MP-a as a mask.

In an embodiment, in the operation of forming the conductive partition wall PW, the first conductive layer INL1 may be mainly etched rather than the second conductive layer INL2, through a wet-etching process, by using an etching solution having an etch rate of the first conductive layer INL1 greater than an etch rate of the second conductive layer INL2. Shapes of inner surfaces of the first conductive layer INL1 and the second conductive layer INL2 may be changed during the second etching process, and the conductive partition wall PW may have an undercut shape on a cross section. In an embodiment, for example, a side surface of the first conductive layer INL1 may be formed to be more recessed than a side surface of the second conductive layer INL2. That is, on a plane, the side surface of the second conductive layer INL2 may be formed to be more adjacent to the center of the lower electrode AE than the side surface of the first conductive layer INL1 is. The side surface of the second conductive layer INL2 may protrude further toward the center of the partition wall opening OPU1 than the side surface of the first conductive layer INL1, and a portion protruding from the second conductive layer INL2 may form a tip-portion. Accordingly, the area of the lower opening OPU1-1 formed in the first conductive layer INL1 may be greater than the area of the upper opening OPU1-2 defined in the second conductive layer INL2.

Referring to FIG. 8D, the preliminary operation of forming a pixel region may include etching the protection pattern TPL through a third etching process. The protection pattern TPL may include a first layer TPL-1 formed on an upper surface of the lower electrode AE, and a second layer TPL-2 not in contact with the lower electrode AE and formed on the first layer TPL-1. The first layer TPL-1 and the second layer TPL-2 may be removed through the third etching process. The first layer TPL-1 and the second layer TPL-2 are removed through a single-etching process. In an embodiment, for example, the first layer TPL-1 and the second layer TPL-2 may be wet-etched.

In an embodiment, some regions of the lower electrode AE may be exposed through the third etching process without being covered by the protection pattern TPL. That is, an opening TPL-OP may be defined in the protection pattern TPL. The opening TPL-OP of the protection pattern TPL may correspond to the light-emitting opening OPE defined by the pixel-defining film PDL. As the protection pattern TPL is etched through a wet-etching process, the planar area of the opening TPL-OP may be greater than the planar area of the light-emitting opening OPE.

In the preliminary operation of forming a pixel region, the third etching process may be performed under the condition that etching selectivity between the protection pattern TPL and the lower electrode AE is high. In an embodiment, the third etching process may include a wet-etching process. The etching solution having an etch rate for the protection pattern TPL higher than an etch rate for the lower electrode AE may be used during the wet-etching process of etching the protection pattern TPL. Accordingly, the lower electrode AE may not be damaged during the wet-etching process.

In an embodiment, the first layer TPL-1 is formed from (or using) molybdenum tantalum oxide (MoTaOₓ), and the second layer TPL-2 may be formed from indium zinc oxide (IZO) or indium gallium zinc oxide (IGZO). Since the first layer TPL-1 and the second layer TPL-2 are formed from different materials from each other, an etching solution used during the wet-etching process may have relatively higher etching selectivity for any one layer among the first layer TPL-1 and the second layer TPL-2. In an embodiment, for example, in the preliminary operation of forming a pixel region, an etching solution having etching selectivity for the first layer TPL-1 higher than that of the second layer TPL-2 may be used during the wet-etching process. Accordingly, in a section corresponding to a region where the light-emitting opening OPE is formed, the second layer TPL-2 may be fully removed, but at least a portion of the first layer TPL-1 may remain.

According to an embodiment of the invention, since the first layer TPL-1 is formed from molybdenum tantalum oxide (MoTaOₓ) and thus has a solubility appropriate for DI water or tetramethylammonium hydroxide (TMAH), it is possible to remove the first layer TPL-1 remaining in a portion corresponding to the light-emitting opening OPE of an upper surface of the lower electrode AE through a cleaning process performed before a subsequent process after the third etching process. In an embodiment, the first layer TPL-1 formed from MoTaOₓ may contain tantalum (Ta) in an amount of about 2 at% or greater with respect to the total content of the first layer TPL-1 and may be used by adjusting the solubility to be appropriate for DI water or tetramethylammonium hydroxide (TMAH).

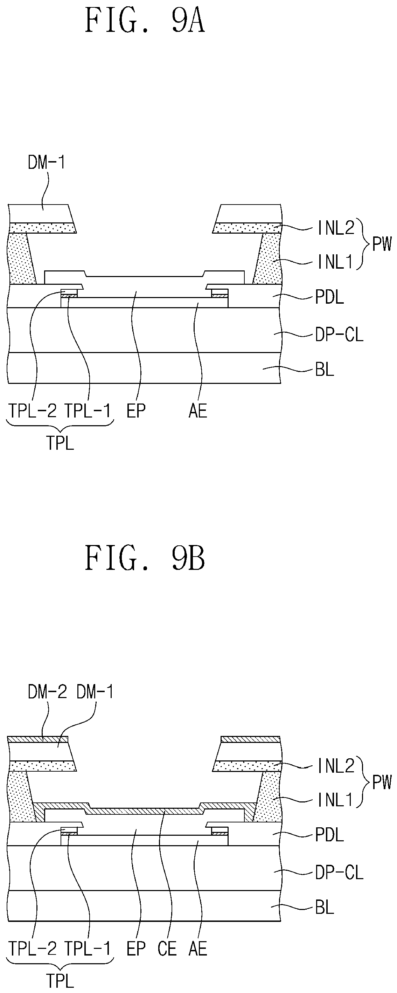

FIGS. 9A to 9D are cross-sectional views respectively illustrating some operations of a method of manufacturing a display panel according to an embodiment of the invention. FIGS. 9A to 9D are cross-sectional views illustrating operations of forming a portion corresponding to the light-emitting region illustrated in FIG. 6. The description described with reference to FIGS. 9A to 9D may be applied to each of the first to third light-emitting regions PXA-R, PXA-G and PXA-B of the display panel DP.

Referring to FIG. 9A, the operation of forming the light-emitting region may include forming a light-emitting pattern EP and a first dummy layer DM-1. The light-emitting pattern EP and the first dummy layer DM-1 may be formed by depositing a light-emitting material onto a lower electrode AE and a pixel-defining film PDL. The light-emitting material may be provided on the lower electrode AE and the pixel-defining film PDL using a thermal evaporation deposition after the photomask pattern MP-a (see FIG. 8D) is removed.

In an embodiment, for example, the light-emitting pattern EP may be the light-emitting material formed on the lower electrode AE. Also, the first dummy layer DM-1 may be the light-emitting material formed at a position where the light-emitting pattern EP is not formed. In an embodiment, for example, the first dummy layer DM-1 may be the light-emitting material formed on a conductive partition wall PW.

Referring to FIG. 9B, the operation of forming the light-emitting region may include forming an upper electrode CE and a second dummy layer DM-2. The upper electrode CE and the second dummy layer DM-2 may be respectively formed on the light-emitting pattern EP and the first dummy layer DM-1. The upper electrode CE and the second dummy layer DM-2 may be formed through a sputtering process.

In an embodiment, the upper electrode CE is formed on the light-emitting pattern EP. Also, the second dummy layer DM-2 may be formed on the first dummy layer DM-1. In such an embodiment, the upper electrode CE may be formed to be in contact with and to be electrically connected to at least a portion of a side surface of the conductive partition wall PW.

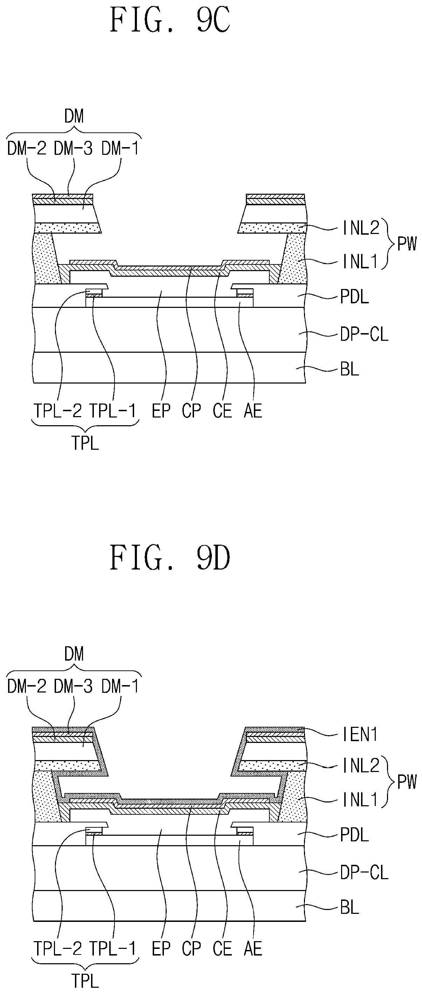

Referring to FIG. 9C, the operation of the light-emitting region may include forming a capping pattern CP and a third dummy layer DM-3. The capping pattern CP and the third dummy layer DM-3 may be respectively formed on the upper electrode CE and the second dummy layer DM-2. In some embodiments, the operation of forming the capping pattern CP and the third dummy layer DM-3 may be omitted.

Referring to FIG. 9D, the operation of forming the light-emitting region may include forming a first inorganic encapsulation film IEN1. The first inorganic encapsulation film IEN1 may be formed to cover the upper electrode CE, the dummy pattern DM, and the exposed conductive partition wall PW. The first inorganic encapsulation film IEN1 may be formed through a chemical vapor deposition.

In an embodiment, a method of manufacturing a display panel may include forming the organic encapsulation film OEN (see FIG. 6) and the second inorganic encapsulation film IEN2 (see FIG. 6) on the display element layer DP-OLED (see FIG. 6).

In such an embodiment, the organic encapsulation film OEN may be formed to have a relatively greater thickness to planarize a step of the display element layer DP-OLED. Also, the organic encapsulation film OEN may be formed to fill the dummy opening OPD between the dummy patterns DM. The second inorganic encapsulation film IEN2 is formed on the organic encapsulation film OEN, so that the display element layer DP-OLED may be protected against moisture and oxygen.

A display panel according to an embodiment may achieve a high-resolution display and effectively prevent an electronic element from being deteriorated, thereby improving reliability.

Also, in a method of manufacturing a display panel according to an embodiment of the invention, an additional mask is not used for patterning an organic pattern including a light-emitting material in each pixel, such that a display panel may be manufactured with a simplified process and a reduced process cost.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display panel (DP) comprising:
a base layer (BL);
a lower electrode (AE) disposed on the base layer (BL);
a protection pattern (TPL) disposed on the lower electrode (AE),
a pixel-defining film (PDL) disposed on the base layer (BL) to cover at least a portion of the protection pattern (TPL), wherein a light-emitting opening (OPE) corresponding to the lower opening (TPL-OP) is defined in the pixel-defining film (PDL);
a conductive partition wall (PW) disposed on the pixel-defining film (PDL), wherein a partition wall opening (OPU) corresponding to the light-emitting opening (OPE) is defined in the conductive partition wall (PW);
a light-emitting pattern (EP) disposed in the lower opening (TPL-OP), the light-emitting opening (OPE), and the partition wall opening (OPU) and disposed on the lower electrode (AE); and
an upper electrode (CE) disposed on the light-emitting pattern (EP), and in contact with an inner surface of the conductive partition wall (PW) defining the partition wall opening (OPU),
**characterised in that** a lower opening (TPL-OP) partially exposing an upper surface of the lower electrode (AE) is defined in the protection pattern (TPL); and **in that** the protection pattern (TPL) includes:
a first layer (TPL-1) including molybdenum tantalum oxide (MoTaOₓ) and disposed on the lower electrode (AE); and
a second layer (TPL-2) including a transparent conductive oxide and disposed on the first layer (TPL-1).

2. The display panel (DP) of claim 1, wherein
the first layer (TPL-1) is in direct contact with the lower electrode (AE), and
the second layer (TPL-2) is not in contact with the lower electrode (AE).

3. The display panel (DP) of claim 1 or claim 2, wherein the first layer (TPL-1) has a thickness less than that of the second layer (TPL-2).

4. The display panel (DP) of claim 3, wherein the first layer (TPL-1) has a thickness in a range of about 50 Å to about 200 Å.

5. The display panel (DP) of any one of claims 1 to 4, wherein the first layer (TPL-1) includes tantalum (Ta) in an amount in a range of about 2 at% or greater.

6. The display panel (DP) of any one of claims 1 to 5, wherein the transparent conductive oxide comprises indium zinc oxide (IZO), zinc oxide (ZnO), or indium gallium zinc oxide (IGZO).

7. The display panel (DP) of any one of claims 1 to 6, wherein
the conductive partition wall (PW) comprises a first conductive layer (INL1) disposed on the pixel-defining film (PDL) and having a first conductivity, and
a second conductive layer (INL2) having a second conductivity less than the first conductivity, and disposed on the first conductive layer (INL1).

8. The display panel (DP) of claim 7, wherein
the first conductive layer (INL1) has a first thickness, and
the second conductive layer (INL2) has a second thickness less than the first thickness.

9. A method of manufacturing a display panel (DP), the method comprising:
preparing a preliminary display panel including a base layer (BL), a lower electrode (AE) disposed on the base layer (BL), a protection pattern (TPL) disposed on the lower electrode (AE), a preliminary pixel-defining film (P-PDL) covering the lower electrode (AE) and the protection pattern (TPL), a preliminary conductive partition wall (P-PW) disposed on the preliminary pixel-defining film (P-PDL);
forming a partition wall opening (OPU1) corresponding to the lower electrode (AE) in the preliminary conductive partition wall (P-PW);
forming a light-emitting opening (OPE) in the preliminary pixel-defining film (P-PDL);
forming an opening (TPL-OP) in the protection pattern (TPL);
forming a light-emitting pattern (EP), by depositing a light-emitting material onto the lower electrode (AE), inside the partition wall opening (OPU1), the light-emitting opening (OPE) and the opening (TPL-OP); and
providing an upper electrode (CE) on the light-emitting pattern (EP),
wherein the protection pattern (TPL) includes a first layer (TPL-1) disposed on the lower electrode (AE) and a second layer (TPL-2) disposed on the first layer (TPL-1), and
the opening (TPL-OP) is formed by performing a single etching process on the first layer (TPL-1) and the second layer (TPL-2).

10. The method of claim 9, wherein
the single etching process comprises a wet-etching process and a cleaning process,
the second layer (TPL-2) comprises a transparent conductive oxide and is removed through the wet-etching process, and
the first layer (TPL-1) comprises molybdenum tantalum oxide (MoTaOₓ) and is removed through the cleaning process.

## Patentansprüche

1. Anzeigefeld (DP), umfassend:
eine Basisschicht (BL);
eine untere Elektrode (AE), die auf der Basisschicht (BL) angeordnet ist;
ein Schutzmuster (TPL), das auf der unteren Elektrode (AE) angeordnet ist,
einen auf der Basisschicht (BL) angeordneten pixeldefinierenden Film (PDL), der mindestens einen Teil des Schutzmusters (TPL) bedeckt, wobei in dem pixeldefinierenden Film (PDL) eine der unteren Öffnung (TPL-OP) entsprechende lichtemittierende Öffnung (OPE) definiert ist;
eine leitfähige Trennwand (PW), die auf dem pixeldefinierenden Film (PDL) angeordnet ist, wobei in der leitfähigen Trennwand (PW) eine Trennwandöffnung (OPU) definiert ist, die der lichtemittierenden Öffnung (OPE) entspricht;
ein in der unteren Öffnung (TPL-OP), der lichtemittierenden Öffnung (OPE) und der Trennwandöffnung (OPU) angeordnetes lichtemittierendes Muster (EP), das auf der unteren Elektrode (AE) angeordnet ist; und
eine obere Elektrode (CE), die auf dem lichtemittierenden Muster (EP) angeordnet ist und mit einer Innenfläche der leitfähigen Trennwand (PW) in Kontakt steht, welche die Öffnung der Trennwand (OPU) definiert,
**dadurch gekennzeichnet, dass** im Schutzmuster (TPL) eine untere Öffnung (TPL-OP) definiert ist, die eine Oberseite der unteren Elektrode (AE) teilweise freilegt; und dadurch, dass das Schutzmuster (TPL) Folgendes beinhaltet:
eine erste Schicht (TPL-1), die Molybdän-Tantal-Oxid (MoTaOₓ) beinhaltet und auf der unteren Elektrode (AE) angeordnet ist; und
eine zweite Schicht (TPL-2), die ein transparentes leitfähiges Oxid beinhaltet und auf der ersten Schicht (TPL-1) angeordnet ist.

2. Anzeigefeld (DP) nach Anspruch 1, wobei
die erste Schicht (TPL-1) in direktem Kontakt mit der unteren Elektrode (AE) steht und
die zweite Schicht (TPL-2) nicht in Kontakt mit der unteren Elektrode (AE) steht.

3. Anzeigefeld (DP) nach Anspruch 1 oder Anspruch 2, wobei die erste Schicht (TPL-1) eine geringere Dicke aufweist als die zweite Schicht (TPL-2).

4. Anzeigefeld (DP) nach Anspruch 3, wobei die erste Schicht (TPL-1) eine Dicke im Bereich von etwa 50 Å bis etwa 200 Åaufweist.

5. Anzeigefeld (DP) nach einem der Ansprüche 1 bis 4, wobei die erste Schicht (TPL-1) Tantal (Ta) in einem Bereich von etwa 2 Atomprozent oder mehr beinhaltet.

6. Anzeigefeld (DP) nach einem der Ansprüche 1 bis 5, wobei das transparente leitfähige Oxid Indiumzinkoxid (IZO), Zinkoxid (ZnO) oder Indiumgalliumzinkoxid (IGZO) umfasst.

7. Anzeigefeld (DP) nach einem der Ansprüche 1 bis 6, wobei
die leitfähige Trennwand (PW) eine erste leitfähige Schicht (INL1) umfasst, die auf dem pixeldefinierenden Film (PDL) angeordnet ist und eine erste Leitfähigkeit aufweist, und
eine zweite leitfähige Schicht (INL2), die eine zweite Leitfähigkeit aufweist, die geringer ist als die erste Leitfähigkeit, und die auf der ersten leitfähigen Schicht (INL1) angeordnet ist.

8. Anzeigefeld (DP) nach Anspruch 7, wobei
die erste leitfähige Schicht (INL1) eine erste Dicke hat und
die zweite leitfähige Schicht (INL2) eine zweite Dicke hat, die geringer ist als die erste Dicke.

9. Verfahren zum Herstellen eines Anzeigefelds (DP), wobei das Verfahren Folgendes umfasst:
Herstellen eines vorläufigen Anzeigefelds, das eine Basisschicht (BL), eine auf der Basisschicht (BL) angeordnete untere Elektrode (AE), ein auf der unteren Elektrode (AE) angeordnetes Schutzmuster (TPL), einen die untere Elektrode (AE) und das Schutzmuster (TPL) bedeckenden, vorläufigen, pixeldefinierenden Film (P-PDL), eine auf dem vorläufigen pixeldefinierenden Film (P-PDL) angeordnete vorläufige leitfähige Trennwand (P-PW) beinhaltet;
Bilden einer Trennwandöffnung (OPU1), die der unteren Elektrode (AE) in der vorläufigen leitfähigen Trennwand (P-PW) entspricht;
Bilden einer lichtemittierenden Öffnung (OPE) in dem vorläufigen pixeldefinierenden Film (P-PDL);
Bilden einer Öffnung (TPL-OP) im Schutzmuster (TPL);
Bilden eines lichtemittierenden Musters (EP) durch Aufbringen eines lichtemittierenden Materials auf die untere Elektrode (AE), innerhalb der Trennwandöffnung (0PU1), der lichtemittierenden Öffnung (OPE) und der Öffnung (TPL-OP); und
Bereitstellen einer oberen Elektrode (CE) auf dem lichtemittierenden Muster (EP),
wobei das Schutzmuster (TPL) eine erste Schicht (TPL-1) auf der unteren Elektrode (AE) und eine zweite Schicht (TPL-2) auf der ersten Schicht (TPL-1) beinhaltet, und
die Öffnung (TPL-OP) durch Durchführen eines einzigen Ätzprozesses an der ersten Schicht (TPL-1) und der zweiten Schicht (TPL-2) gebildet wird.

10. Verfahren nach Anspruch 9, wobei
der einzelne Ätzprozess einen Nassätzprozess und einen Reinigungsprozess umfasst,
die zweite Schicht (TPL-2) ein transparentes leitfähiges Oxid umfasst und durch den Nassätzprozess entfernt wird und
die erste Schicht (TPL-1) Molybdän-Tantal-Oxid (MoTaOₓ) umfasst und durch den Reinigungsprozess entfernt wird.

## Revendications

1. Panneau d'affichage (DP) comprenant :
une couche de base (BL) ;
une électrode inférieure (AE) disposée sur la couche de base (BL) ;
un motif de protection (TPL) disposé sur l'électrode inférieure (AE),
un film de définition de pixels (PDL) disposé sur la couche de base (BL) pour couvrir au moins une partie du motif de protection (TPL), dans lequel une ouverture électroluminescente (OPE) correspondant à l'ouverture inférieure (TPL-OP) est définie dans le film de définition de pixels (PDL) ;
une paroi de séparation conductrice (PW) disposée sur le film définissant les pixels (PDL), dans lequel une ouverture de paroi de séparation (OPU) correspondant à l'ouverture électroluminescente (OPE) est définie dans la paroi de séparation conductrice (PW) ;
un motif électroluminescent (EP) disposé dans l'ouverture inférieure (TPL-OP), l'ouverture électroluminescente (OPE) et l'ouverture de la paroi de séparation (OPU) et disposé sur l'électrode inférieure (AE) ; et
une électrode supérieure (CE) disposée sur le motif électroluminescent (EP) et en contact avec une surface intérieure de la paroi de séparation conductrice (PW) définissant l'ouverture de la paroi (OPU),
**caractérisé en ce qu'**une ouverture inférieure (TPL-OP) exposant partiellement une surface supérieure de l'électrode inférieure (AE) est définie dans le motif de protection (TPL) ; et **en ce que** le motif de protection (TPL) inclut :
une première couche (TPL-1) incluant de l'oxyde de molybdène-tantale (MoTaOₓ) et disposée sur l'électrode inférieure (AE) ; et
une seconde couche (TPL-2) incluant un oxyde conducteur transparent et disposée sur la première couche (TPL-1).

2. Panneau d'affichage (DP) selon la revendication 1, dans lequel
la première couche (TPL-1) est en contact direct avec l'électrode inférieure (AE), et
la seconde couche (TPL-2) n'est pas en contact avec l'électrode inférieure (AE).

3. Panneau d'affichage (DP) selon la revendication 1 ou la revendication 2, dans lequel la première couche (TPL-1) présente une épaisseur inférieure à celle de la seconde couche (TPL-2).

4. Panneau d'affichage (DP) selon la revendication 3, dans lequel la première couche (TPL-1) présente une épaisseur comprise entre environ 50 Å et environ 200 Å.

5. Panneau d'affichage (DP) selon l'une quelconque des revendications 1 à 4, dans lequel la première couche (TPL-1) inclut du tantale (Ta) en une quantité d'environ 2 % atomiques ou plus.

6. Panneau d'affichage (DP) selon l'une quelconque des revendications 1 à 5, dans lequel l'oxyde conducteur transparent comprend de l'oxyde d'indium-zinc (IZO), de l'oxyde de zinc (ZnO) ou de l'oxyde d'indium-gallium-zinc (IGZO).

7. Panneau d'affichage (DP) selon l'une quelconque des revendications 1 à 6, dans lequel
la paroi de séparation conductrice (PW) comprend une première couche conductrice (INL1) disposée sur le film définissant les pixels (PDL) et présentant une première conductivité, et
une seconde couche conductrice (INL2) présentant une seconde conductivité inférieure à la première conductivité, et disposée sur la première couche conductrice (INL1).

8. Panneau d'affichage (DP) selon la revendication 7, dans lequel
la première couche conductrice (INL1) présente une première épaisseur, et
la seconde couche conductrice (INL2) présente une seconde épaisseur inférieure à la première épaisseur.

9. Procédé de fabrication d'un panneau d'affichage (DP), le procédé comprenant :
la préparation d'un panneau d'affichage préliminaire incluant une couche de base (BL), une électrode inférieure (AE) disposée sur la couche de base (BL), un motif de protection (TPL) disposé sur l'électrode inférieure (AE), un film de définition de pixels préliminaire (P-PDL) recouvrant l'électrode inférieure (AE) et le motif de protection (TPL), une paroi de séparation conductrice préliminaire (P-PW) disposée sur le film de définition de pixels préliminaire (P-PDL) ;
la formation d'une ouverture dans la paroi de séparation (OPU1) correspondant à l'électrode inférieure (AE) dans la paroi de séparation conductrice préliminaire (P-PW) ;
la formation d'une ouverture électroluminescente (OPE) dans le film préliminaire de définition des pixels (P-PDL) ;
la formation d'une ouverture (TPL-OP) dans le motif de protection (TPL) ;
la formation d'un motif électroluminescent (EP), en déposant un matériau électroluminescent sur l'électrode inférieure (AE), à l'intérieur de l'ouverture de la paroi de séparation (OPU1), de l'ouverture électroluminescente (OPE) et de l'ouverture (TPL-OP) ; et
la fourniture d'une électrode supérieure (CE) sur le motif électroluminescent (EP),
dans lequel le motif de protection (TPL) inclut une première couche (TPL-1) disposée sur l'électrode inférieure (AE) et une seconde couche (TPL-2) disposée sur la première couche (TPL-1), et
l'ouverture (TPL-OP) est formée en effectuant un processus de gravure unique sur la première couche (TPL-1) et la seconde couche (TPL-2).

10. Procédé selon la revendication 9, dans lequel
le processus de gravure unique comprend un processus de gravure humide et un processus de nettoyage.
la seconde couche (TPL-2) comprend un oxyde conducteur transparent et est éliminée par le processus de gravure humide, et
la première couche (TPL-1) comprend de l'oxyde de molybdène-tantale (MoTaOₓ) et est éliminée par le processus de nettoyage.
